# EUROPEAN PATENT APPLICATION

(11) **EP 4 823 299 A1**
(43) Date of publication of application: **14.10.2026**
(21) Application number: 25747571.5
(22) Date of filing: 17.01.2025
(51) Int. Cl.: H10K 59/131, H10K 59/124

(54) **DISPLAY PANEL AND DISPLAY APPARATUS**

(30) Priority: 30.01.2024 CN 202410129884
(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: JI, Fengli, Daxing District, Beijing 100176 (CN); LU, Yanwei, Daxing District, Beijing 100176 (CN); DENG, Jiangtao, Daxing District, Beijing 100176 (CN); YUAN, Xiaomin, Daxing District, Beijing 100176 (CN); YAN, Zhuoran, Daxing District, Beijing 100176 (CN); CHENG, Yudiao, Daxing District, Beijing 100176 (CN); ZHANG, Shun, Daxing District, Beijing 100176 (CN)
(74) Representative: Durán-Corretjer, S.L.P.
(86) International application number: PCT/CN2025/072995
(87) International publication number: WO 2025/161999

(57) **Abstract**

A display panel, comprising: a substrate; a plurality of sub-pixels and a plurality of data lines, which are located in a display area; and a plurality of data fan-out lines and a plurality of control signal lines, which are located in a first frame area. The plurality of data fan-out lines comprise a first group of data fan-out lines and a second group of data fan-out lines, and the plurality of control signal lines comprise a first group of control signal lines and a second group of control signal lines, wherein the number of control signal lines in the first group of control signal lines is greater than the number of control signal lines in the second group of control signal lines. Each data fan-out line in the first group of data fan-out lines overlaps with an orthographic projection of the first group of control signal lines on the substrate, and each data fan-out line in the second group of data fan-out lines overlaps with an orthographic projection of the second group of control signal lines on the substrate. At least one organic insulating layer is provided between each data fan-out line and a control signal line, the orthographic projection of which on the substrate overlaps with the data fan-out line.

## Description

The present application claims the priority to Chinese Patent Application No. 202410129884.4, filed on January 30, 2024 and entitled "Display Panel and Display Apparatus", contents of which should be construed as being incorporated into the present application by reference.

### Technical Field

The present disclosure relates to, but is not limited to, the field of display technologies, in particular to a display panel and a display apparatus.

### Background

An organic light emitting diode (OLED) is an active light emitting display device and has advantages such as self-luminescence, a wide viewing angle, a high contrast ratio, low power consumption, an extremely high response speed, etc. With continuous development of display technologies, a display apparatus in which an OLED is used as a light emitting device and signal control is performed by a thin film transistor (TFT) has become a mainstream product in the field of display at present.

### Summary

The following is a summary of subject matters described herein in detail. This summary is not intended to limit the protection scope of claims.

Embodiments of the present application provide a display panel and a display apparatus.

In one aspect, an embodiment provides a display panel, including: a base substrate, a plurality of sub-pixels, a plurality of data lines, a plurality of data fan-out lines, and a plurality of control signal lines. The base substrate includes: a display region, and a first bezel region located at a side of the display region. The plurality of sub-pixels and the plurality of data lines are located in the display region, the plurality of data lines are connected with the plurality of sub-pixels and configured to provide data signals to the plurality of sub-pixels. The plurality of data fan-out lines and the plurality of control signal lines are located in the first bezel region. The plurality of data fan-out lines are configured to provide data signals to the plurality of data lines; the plurality of data fan-out lines include: a first group of data fan-out lines and a second group of data fan-out lines, and the plurality of control signal lines include: a first group of control signal lines and a second group of control signal lines. A quantity of control signal lines in the first group of control signal lines is greater than a quantity of control signal lines in the second group of control signal lines. An orthographic projection of each data fan-out line in the first group of data fan-out lines on the base substrate is overlapped with an orthographic projection of the first group of control signal lines on the base substrate, and an orthographic projection of each data fan-out line in the second group of data fan-out lines on the base substrate is overlapped with an orthographic projection of the second group of control signal lines on the base substrate. At least one organic insulation layer is disposed between a data fan-out line of the plurality of data fan-out lines and a control signal line whose orthographic projection on the base substrate is overlapped with an orthographic projection of the data fan-out line on the base substrate.

In some exemplary implementation modes, a control signal line of the plurality of control signal lines includes a first control line segment, an orthographic projection of the first control line segment on the base substrate is overlapped with an orthographic projection of the first group of data fan-out lines or the second group of data fan-out lines on the base substrate, the first control line segment is located at a side of the first group of data fan-out lines or the second group of data fan-out lines away from the base substrate, and the first control line segment intersects with an extension direction of the plurality of data fan-out lines.

In some exemplary implementation modes, in a direction perpendicular to the display panel, the display panel at least includes: a first gate metal layer, a second gate metal layer, a first source-drain metal layer, and a second source-drain metal layer disposed along a direction away from the base substrate; at least a first planarization layer is disposed between the first source-drain metal layer and the second source-drain metal layer. The plurality of data fan-out lines are located in at least one of the first gate metal layer and the second gate metal layer, and first control line segments of the plurality of control signal lines are located in the second source-drain metal layer.

In some exemplary implementation modes, in a direction perpendicular to the display panel, the display panel at least includes: a first gate metal layer, a second gate metal layer, a first source-drain metal layer, a second source-drain metal layer, and a third source-drain metal layer disposed along a direction away from the base substrate; at least a first planarization layer is disposed between the first source-drain metal layer and the second source-drain metal layer, and at least a second planarization layer is disposed between the second source-drain metal layer and the third source-drain metal layer. The plurality of data fan-out lines are located in at least one of the first gate metal layer and the second gate metal layer, and first control line segments of the plurality of control signal lines are located in the third source-drain metal layer.

In some exemplary implementation modes, the plurality of data fan-out lines include: a plurality of first data fan-out lines located in the first gate metal layer and a plurality of second data fan-out lines located in the second gate metal layer. The plurality of first data fan-out lines and the plurality of second data fan-out lines are arranged at intervals one by one, and orthographic projections of the plurality of first data fan-out lines and the plurality of second data fan-out lines on the base substrate are not overlapped.

In some exemplary implementation modes, the control signal line further includes a second control line segment and a third control line segment, the second control line segment is connected with one end of the first control line segment, the third control line segment is connected with the other end of the first control line segment, and orthographic projections of the second control line segment and the third control line segment on the base substrate are not overlapped with the orthographic projection of the plurality of data fan-out lines on the base substrate; the second control line segment and the third control line segment are of a same layer structure, and are located at a side of the first control line segment close to the base substrate.

In some exemplary implementation modes, an orthographic projection of each data fan-out line in the first group of data fan-out lines on the base substrate has a first overlapping area with the orthographic projection of the first group of control signal lines on the base substrate, and an orthographic projection of each data fan-out line in the second group of data fan-out lines on the base substrate has a second overlapping area with the orthographic projection of the second group of control signal lines on the base substrate, a ratio of the first overlapping area to the second overlapping area ranging from 0.9 to 1.1.

In some exemplary implementation modes, each data fan-out line in the first group of data fan-out lines includes a first sub-line segment of which an orthographic projection on the base substrate is overlapped with the orthographic projection of the first group of control signal lines on the base substrate. Each data fan-out line in the second group of data fan-out lines includes a second sub-line segment of which an orthographic projection on the base substrate is overlapped with the orthographic projection of the second group of control signal lines on the base substrate. A line width of the first sub-line segment is smaller than a line width of the second sub-line segment.

In some exemplary implementation modes, a ratio of the line width of the second sub-line segment to the line width of the first sub-line segment is greater than 1 and smaller than 2.

In some exemplary implementation modes, each data fan-out line in the first group of data fan-out lines further includes: a third sub-line segment connected with one end of the first sub-line segment, and a fourth sub-line segment connected with the other end of the first sub-line segment; orthographic projections of the third sub-line segment and the fourth sub-line segment on the base substrate are not overlapped with the orthographic projection of the first group of control signal lines on the base substrate; the first sub-line segment, the third sub-line segment, and the fourth sub-line segment of each data fan-out line in the first group of data fan-out lines are of an interconnected integral structure. Each data fan-out line in the second group of data fan-out lines further includes: a fifth sub-line segment connected with one end of the second sub-line segment, and a sixth sub-line segment connected with the other end of the second sub-line segment; orthographic projections of the fifth sub-line segment and the sixth sub-line segment on the base substrate are not overlapped with the orthographic projection of the second group of control signal lines on the base substrate. The second sub-line segment, the fifth sub-line segment, and the sixth sub-line segment of each data fan-out line in the second group of data fan-out lines are of an interconnected integral structure. The first sub-line segment, the third sub-line segment, the fourth sub-line segment, the fifth sub-line segment, and the sixth sub-line segment have a same line width.

In some exemplary implementation modes, each data fan-out line in the first group of data fan-out lines includes a first sub-line segment of which an orthographic projection on the base substrate is overlapped with the orthographic projection of the first group of control signal lines on the base substrate. Each data fan-out line in the second group of data fan-out lines includes a second sub-line segment of which an orthographic projection on the base substrate is overlapped with the orthographic projection of the second group of control signal lines on the base substrate. The orthographic projection of the first sub-line segment on the base substrate is a trace with a straight line shape, and the orthographic projection of the second sub-line segment on the base substrate is a serpentine trace.

In some exemplary implementation modes, each data fan-out line in the second group of data fan-out lines further includes: a fifth sub-line segment connected with one end of the second sub-line segment, and a sixth sub-line segment connected with the other end of the second sub-line segment; orthographic projections of the fifth sub-line segment and the sixth sub-line segment on the base substrate are not overlapped with the orthographic projection of the second group of control signal lines on the base substrate. The second sub-line segment, the fifth sub-line segment, and the sixth sub-line segment of each data fan-out line in the second group of data fan-out lines are of an interconnected integral structure; an orthographic projection of a fifth sub-line segment or a sixth sub-line segment of at least one data fan-out line in the second group of data fan-out lines on the base substrate is a serpentine trace.

In some exemplary implementation modes, each control signal line in the first group of control signal lines includes a first control line segment of which an orthographic projection on the base substrate is overlapped with an orthographic projection of the first group of data fan-out lines on the base substrate; each control signal line in the second group of control signal lines includes a first control line segment of which an orthographic projection on the base substrate is overlapped with an orthographic projection of the second group of data fan-out lines on the base substrate; a line width of a first control line segment of at least one control signal line in the second group of control signal lines is greater than a line width of a first control line segment of a control signal line in the first group of control signal lines.

In some exemplary implementation modes, the base substrate further includes a second bezel region and a third bezel region located at two sides of the display region along a first direction, and the second bezel region and the third bezel region are each in communication with the first bezel region. The display panel further includes a first group of gate drive circuits located in the second bezel region and a second group of gate drive circuits located in the third bezel region, wherein a quantity of gate drive circuits included in the first group of gate drive circuits is greater than a quantity of gate drive circuits included in the second group of gate drive circuits. The first group of control signal lines include a plurality of first drive control lines configured to provide drive control signals to the first group of gate drive circuits. The second group of control signal lines include a plurality of second drive control lines configured to provide drive control signals to the second group of gate drive circuits.

In some exemplary implementation modes, at least one sub-pixel of the plurality of sub-pixels includes a pixel circuit. The first group of gate drive circuits include a light emitting drive circuit, a first reset drive circuit, and a second reset drive circuit; the light emitting drive circuit is configured to provide a light emitting control signal to the pixel circuit, the first reset drive circuit is configured to provide a first reset control signal to the pixel circuit, and the second reset drive circuit is configured to provide a second reset control signal to the pixel circuit. The second group of gate drive circuits include a first scan drive circuit and a second scan drive circuit; the first scan drive circuit is configured to provide a first scan signal to the pixel circuit, and the second scan drive circuit is configured to provide a second scan signal to the pixel circuit.

In another aspect, an embodiment provides a display apparatus including the aforementioned display panel.

In another aspect, an embodiment provides a display panel, including: a base substrate, a plurality of sub-pixels, a plurality of data lines, a plurality of data fan-out lines, and a plurality of control signal lines. The base substrate includes: a display region, and a first bezel region located at a side of the display region. The plurality of sub-pixels and the plurality of data lines are located in the display region, wherein the plurality of data lines are connected with the plurality of sub-pixels and configured to provide data signals to the plurality of sub-pixels. The plurality of data fan-out lines and the plurality of control signal lines are located in the first bezel region, and the plurality of data fan-out lines are configured to provide data signals to the plurality of data lines. The plurality of data fan-out lines include a first group of data fan-out lines and a second group of data fan-out lines, and the plurality of control signal lines include a first group of control signal lines and a second group of control signal lines; a quantity of control signal lines in the first group of control signal lines is greater than a quantity of control signal lines in the second group of control signal lines. An orthographic projection of each data fan-out line in the first group of data fan-out lines on the base substrate is overlapped with an orthographic projection of the first group of control signal lines on the base substrate, and an orthographic projection of each data fan-out line in the second group of data fan-out lines on the base substrate is overlapped with an orthographic projection of the second group of control signal lines on the base substrate. The orthographic projection of each data fan-out line in the first group of data fan-out lines on the base substrate has a first overlapping area with the orthographic projection of the first group of control signal lines on the base substrate, and the orthographic projection of each data fan-out line in the second group of data fan-out lines on the base substrate has a second overlapping area with the orthographic projection of the second group of control signal lines on the base substrate, a ratio of the first overlapping area to the second overlapping area ranging from 0.9 to 1.1.

In some exemplary implementation modes, each data fan-out line in the first group of data fan-out lines includes a first sub-line segment of which an orthographic projection on the base substrate is overlapped with the orthographic projection of the first group of control signal lines on the base substrate. Each data fan-out line in the second group of data fan-out lines includes a second sub-line segment of which an orthographic projection on the base substrate is overlapped with the orthographic projection of the second group of control signal lines on the base substrate. A line width of the first sub-line segment is smaller than a line width of the second sub-line segment.

In some exemplary implementation modes, each data fan-out line in the first group of data fan-out lines includes a first sub-line segment of which an orthographic projection on the base substrate is overlapped with the orthographic projection of the first group of control signal lines on the base substrate. Each data fan-out line in the second group of data fan-out lines includes a second sub-line segment of which an orthographic projection on the base substrate is overlapped with the orthographic projection of the second group of control signal lines on the base substrate. The orthographic projection of the first sub-line segment on the base substrate is a trace with a straight line shape, and the orthographic projection of the second sub-line segment on the base substrate is a serpentine trace.

In some exemplary implementation modes, each control signal line in the first group of control signal lines includes a first control line segment of which an orthographic projection on the base substrate is overlapped with an orthographic projection of the first group of data fan-out lines on the base substrate. Each control signal line in the second group of control signal lines includes a first control line segment of which an orthographic projection on the base substrate is overlapped with an orthographic projection of the second group of data fan-out lines on the base substrate. A line width of a first control line segment of at least one control signal line in the second group of control signal lines is greater than a line width of a first control line segment of a control signal line in the first group of control signal lines.

Other features and advantages of the present application will be set forth in the specification which follows, and in part will become apparent from the specification, or may be learned by practice of the present application. Other advantages of the present application may be achieved and obtained through solutions described in the specification and drawings.

### Brief Description of Drawings

Accompanying drawings are intended to provide an understanding of technical solutions of the present application and constitute a part of the specification, and are used to explain the technical solutions of the present application together with the embodiments of the present application, and do not constitute limitations on the technical solutions of the present application.
FIG. 1 is a schematic diagram of a display panel according to at least one embodiment of the present disclosure.
FIG. 2 is an equivalent circuit diagram of a pixel circuit according to at least one embodiment of the present disclosure.
FIG. 3 is a working timing diagram of the pixel circuit provided in FIG. 2.
FIG. 4 is a schematic partial sectional view of a display region according to at least one embodiment of the present disclosure.
FIG. 5 is a schematic diagram of a setting of a gate drive circuit according to at least one embodiment of the present disclosure.
FIG. 6 is a schematic partial plan view of a first bezel region according to at least one embodiment of the present disclosure.
FIG. 7 is a partially enlarged schematic diagram of a region S1 in FIG. 6.
FIG. 8A is a schematic partial sectional view taken along a direction Q1-Q1' in FIG. 7.
FIG. 8B is a schematic partial sectional view taken along a direction Q2-Q2' in FIG. 7.
FIG. 9 is another schematic partial sectional view of a display panel according to at least one embodiment of the present disclosure.
FIG. 10A is another schematic partial sectional view taken along the direction Q1-Q1' in FIG. 7.
FIG. 10B is another schematic partial sectional view taken along the direction Q2-Q2' in FIG. 7.
FIG. 11 is another schematic partial plan view of a first bezel region according to at least one embodiment of the present disclosure.
FIG. 12A is a schematic partially enlarged view of a region S2 in FIG. 11.
FIG. 12B is a partial schematic view of a first group of data fan-out lines in FIG. 12A.
FIG. 13A is a schematic partially enlarged view of a region S3 in FIG. 11.
FIG. 13B is a partial schematic view of a second group of data fan-out lines in FIG. 13A.
FIG. 14A is another schematic partially enlarged view of the region S3 in FIG. 11.
FIG. 14B is a partial schematic view of a second group of data fan-out lines in FIG. 14A.
FIG. 15 is another schematic partially enlarged view of the region S3 in FIG. 11.
FIG. 16A is another schematic partially enlarged view of the region S2 in FIG. 11.
FIG. 16B is a partial schematic view of a first group of data fan-out lines in FIG. 16A.
FIG. 17A is another schematic partially enlarged view of the region S3 in FIG. 11.
FIG. 17B is a partial schematic view of a second group of data fan-out lines in FIG. 17A.
FIG. 18 is a schematic diagram of a display apparatus according to at least one embodiment of the present disclosure.

### Detailed Description

The embodiments of the present disclosure will be described below with reference to the drawings in detail. Implementation modes may be implemented in multiple different forms. Those of ordinary skills in the art may easily understand such a fact that modes and contents may be transformed into various forms without departing from the purpose and scope of the present disclosure. Therefore, the present disclosure should not be explained as being limited to contents recorded in following implementation modes only. The embodiments and features in the embodiments of the present disclosure may be randomly combined with each other if there is no conflict.

In the drawings, a size of one or more constituent elements, a thickness of a layer, or a region is sometimes exaggerated for clarity. Therefore, one mode of the present disclosure is not necessarily limited to the size, and a shape and a size of one or more components in the drawings do not reflect an actual scale. In addition, the accompanying drawings schematically illustrate ideal examples, and one mode of the present disclosure is not limited to shapes, numerical values, or the like shown in the drawings.

Ordinal numerals "first", "second", "third" and the like in the specification are set not to form limits in quantity but only to avoid confusion between constituent elements. In the present disclosure, "plurality" represents two or more than two.

In the specification, for convenience, expressions "central", "above", "below", "front", "back", "vertical", "horizontal", "top", "bottom", "inside", "outside" and the like for indicating directional or positional relationships are used to illustrate positional relationships between the constituent elements with reference to the accompanying drawings, not to indicate or imply that a referred apparatus or element must have a specific orientation or be structured and operated in the specific orientation but only to easily describe the present specification and simplify the description, and thus should not be understood as limitations on the present disclosure. The positional relationships between the constituent elements may be changed as appropriate based on a direction according to which each constituent element is described. Therefore, appropriate replacements based on situations are allowed, which is not limited to the expressions in the specification.

In the specification, unless otherwise explicitly specified and defined, terms "mounting", "coupling", and "connection" should be understood in a broad sense. For example, it may be a fixed connection, a detachable connection, or an integral connection; it may be a mechanical connection or a connection; it may be a direct connection, an indirect connection through a middleware, or internal communication inside two elements. Those of ordinary skills in the art may understand meanings of the aforementioned terms in the present disclosure according to situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. In the specification, the channel region refers to a region through which a current mainly flows.

In the specification, a first electrode may be a drain electrode, and a second electrode may be a source electrode. Or, the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode" are interchangeable in the specification.

In the specification, a "connection" includes a case where constituent elements are connected together through an element with a certain electrical action. The "element with a certain electrical action" is not particularly limited as long as electrical signals between the connected constituent elements may be transmitted. Examples of the "element with a certain electrical action" not only include an electrode and a wiring, but also include a switching element such as a transistor, a resistor, an inductor, a capacitor, other elements with various functions, etc.

In the specification, "parallel" refers to a state in which an angle formed by two straight lines is above -10° and below 10°, and thus may include a state in which the angle is above -5° and below 5°. In addition, "perpendicular" refers to a state in which an angle formed by two straight lines is above 80° and below 100°, and thus may include a state in which the angle is above 85° and below 95°.

In the present disclosure, "about" and "substantially" means that a boundary is not defined strictly and a case within a range of process and measurement errors is allowed.

In the specification, "A extends along a B direction" means that A may include a main body portion and a secondary portion connected with the main body portion, the main body portion is a line, a line segment, or a strip-shaped body, the main body portion extends along the B direction, and a length of the main body portion extending along the B direction is greater than a length of the secondary portion extending along another direction. "A extends along a B direction" in the specification always means "a main body portion of A extends along a B direction".

"A and B are of a same layer structure" mentioned in the specification means that A and B are formed simultaneously through a same patterning process. A "same layer" does not always mean that thicknesses of layers or heights of layers are the same in a section diagram. "An orthographic projection of A contains an orthographic projection of B" means that the orthographic projection of B falls within a range of the orthographic projection of A, or the orthographic projection of A covers the orthographic projection of B.

With the development of display technologies, users' requirements for display quality are gradually increasing. In a lower bezel region of a display panel, capacitance generated by overlapping of traces will affect signals transmitted by the traces to generate a load difference (for example, a load difference of data signals), thereby causing display defects of the display panel. Taking an application of a display panel to wearable products such as watches as an example, overlapping of a data fan-out line that transmits a data signal with a trace transmitting an Alternating Current (AC) signal will cause a signal load difference, resulting in display defects such as bright and dark stripes or split screens.

An embodiment provides a display panel, including: a base substrate, a plurality of sub-pixels, a plurality of data lines, a plurality of data fan-out lines, and a plurality of control signal lines. The base substrate includes: a display region, and a first bezel region located at a side of the display region. The plurality of sub-pixels and the plurality of data lines are located in the display region, and the plurality of data lines are connected with the plurality of sub-pixels and configured to provide data signals to the plurality of sub-pixels. The plurality of data fan-out lines and the plurality of control signal lines are located in the first bezel region, and the plurality of data fan-out lines are configured to provide data signals to the plurality of data lines. The plurality of data fan-out lines include a first group of data fan-out lines and a second group of data fan-out lines, and the plurality of control signal lines include a first group of control signal lines and a second group of control signal lines; a quantity of control signal lines in the first group of control signal lines is greater than a quantity of control signal lines in the second group of control signal lines. An orthographic projection of each data fan-out line in the first group of data fan-out lines on the base substrate is overlapped with an orthographic projection of the first group of control signal lines on the base substrate, and an orthographic projection of each data fan-out line in the second group of data fan-out lines on the base substrate is overlapped with an orthographic projection of the second group of control signal lines on the base substrate. At least one organic insulation layer is disposed between a data fan-out line and a control signal line whose orthographic projections on the base substrate are overlapped.

In the display panel provided by the present embodiment, in the first bezel region, at least one organic insulation layer is disposed between the data fan-out line and the control signal line that are overlapped, which may increase a distance between the data fan-out line and the control signal line that are overlapped, thereby reducing parasitic capacitance between the data fan-out line and the control signal line that are overlapped, and may improve display defects such as low gray scale dark stripes caused by uneven overlapping of the data fan-out line with the control signal line that transmits an AC signal.

In some exemplary implementation modes, a control signal line may include a first control line segment, an orthographic projection of the first control line segment on the base substrate is overlapped with an orthographic projection of the first group of data fan-out lines or the second group of data fan-out lines on the base substrate, the first control line segment may be located at a side of the first group of data fan-out lines or the second group of data fan-out lines away from the base substrate, and the first control line segment may intersect with extension directions of a plurality of data fan-out lines. In some examples, in a direction perpendicular to the display panel, the display panel may at least include: a first gate metal layer, a second gate metal layer, a first source-drain metal layer, and a second source-drain metal layer disposed along a direction away from the base substrate; at least a first planarization layer is disposed between the first source-drain metal layer and the second source-drain metal layer. The plurality of data fan-out lines may be located in at least one of the first gate metal layer and the second gate metal layer, and first control line segments of the plurality of control signal lines may be located in the second source-drain metal layer. In some other examples, in a direction perpendicular to the display panel, the display panel may at least include: a first gate metal layer, a second gate metal layer, a first source-drain metal layer, a second source-drain metal layer, and a third source-drain metal layer disposed along a direction away from the base substrate; at least a first planarization layer may be disposed between the first source-drain metal layer and the second source-drain metal layer, and at least a second planarization layer may be disposed between the second source-drain metal layer and the third source-drain metal layer. The plurality of data fan-out lines may be located in at least one of the first gate metal layer and the second gate metal layer, and first control line segments of the plurality of control signal lines may be located in the third source-drain metal layer. In this example, by setting a film layer in which a first control line segment of a control signal line is located (for example, the first control line segment is located in the second source-drain metal layer or the third source-drain metal layer), a distance between a data fan-out line and the first control line segment of the control signal line that is overlapped with the data fan-out line is increased, , which may reduce parasitic capacitance between the data fan-out line and the control signal line that are overlapped, thereby effectively improving display defects such as low gray scale dark stripes caused by uneven overlapping of the data fan-out line with the control signal line.

In some exemplary implementation modes, the orthographic projection of each data fan-out line in the first group of data fan-out lines on the base substrate and the orthographic projection of the first group of control signal lines on the base substrate have a first overlapping area, and the orthographic projection of each data fan-out line in the second group of data fan-out lines on the base substrate and the orthographic projection of the second group of control signal lines on the base substrate have a second overlapping area, a ratio of the first overlapping area to the second overlapping area may range from 0.9 to 1.1, e.g., may be 1.0. For example, the first overlapping area and the second overlapping area may be substantially the same. In this example, parasitic capacitance between a data fan-out line and a control signal line that are overlapped is adjusted by adjusting an overlapping area of each data fan-out line with a plurality of control signal lines, so that parasitic capacitance between the two groups of data fan-out lines and the control signal lines is substantially the same, thereby optimizing display defects such as low gray scale dark stripes caused by uneven overlapping of the data fan-out line with the control signal line that transmits an AC signal.

In some exemplary implementation modes, each data fan-out line in the first group of data fan-out lines may include a first sub-line segment of which an orthographic projection on the base substrate is overlapped with the orthographic projection of the first group of control signal lines on the base substrate; each data fan-out line in the second group of data fan-out lines may include a second sub-line segment of which an orthographic projection on the base substrate is overlapped with the orthographic projection of the second group of control signal lines on the base substrate. Among them, a line width of the first sub-line segment may be smaller than a line width of the second sub-line segment. For example, a ratio of the line width of the second sub-line segment to the line width of the first sub-line segment may be greater than 1 and smaller than 2. In this example, by increasing the line width of the second sub-line segment of the second group of data fan-out lines, an overlapping area between the second group of data fan-out lines and the second group of control signal lines may be increased, so that a second overlapping area corresponding to a data fan-out line in the second group of data fan-out lines may be substantially the same as a first overlapping area corresponding to a data fan-out line in the first group of data fan-out lines, parasitic capacitance between the second group of data fan-out lines and overlapped traces is increased, so that parasitic capacitance between the two groups of data fan-out lines and the overlapped traces is substantially the same, thereby improving display defects such as low gray scale dark stripes caused by uneven overlapping of the data fan-out line with the control signal line.

In some exemplary implementation modes, each data fan-out line in the first group of data fan-out lines may include a first sub-line segment of which an orthographic projection on the base substrate is overlapped with the orthographic projection of the first group of control signal lines on the base substrate; each data fan-out line in the second group of data fan-out lines may include a second sub-line segment of which an orthographic projection on the base substrate is overlapped with the orthographic projection of the second group of control signal lines on the base substrate. The orthographic projection of the first sub-line segment on the base substrate may be a trace with a straight line shape, and the orthographic projection of the second sub-line segment on the base substrate may be a serpentine trace. Among them, the serpentine trace is a kind of bending curve. For example, after one end of a trace extends along one direction for a certain distance, it bends circuitously and extends along an opposite direction of the direction for a certain distance, and bends circuitously again and extends along the direction. In this way, circuitous bending is repeated for several times to form the serpentine trace. In this example, a serpentine trace design is performed on some of line segments of the second group of data fan-out lines, which may increase an overlapping area between the second group of data fan-out lines and the second group of control signal lines, thereby reducing a difference of parasitic capacitance between the two groups of data fan-out lines and control signal lines overlapped therewith.

In some exemplary implementation modes, each control signal line in the first group of control signal lines may include a first control line segment of which an orthographic projection on the base substrate is overlapped with the orthographic projection of the first group of data fan-out lines on the base substrate; each control signal line in the second group of control signal lines may include a first control line segment of which an orthographic projection on the base substrate is overlapped with the orthographic projection of the second group of data fan-out lines on the base substrate. A line width of a first control line segment of at least one control signal line in the second group of control signal lines may be greater than a line width of a first control line segment of a control signal line in the first group of control signal lines. In this example, by increasing the line width of the first control line segment of the second group of control signal lines, an overlapping area between the second group of data fan-out lines and the second group of control signal lines may be increased, so that parasitic capacitance between the two groups of data fan-out lines and control signal lines overlapped therewith is substantially the same, thereby improving display defects such as low gray scale dark stripes caused by uneven overlapping of the data fan-out lines with the control signal lines.

Solutions of the present embodiment will be illustrated below through some examples.

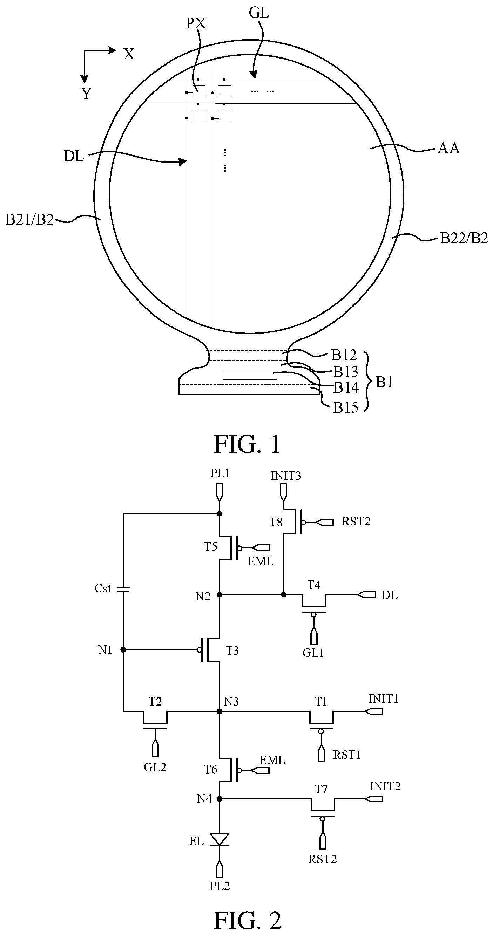

FIG. 1 is a schematic diagram of a display panel according to at least one embodiment of the present disclosure. In some examples, as shown in FIG. 1, the display panel may include: a display region AA, a peripheral bezel region B2 surrounding the display region AA, and a first bezel region B1 located at a side of the display region AA. The first bezel region B1 may be located at a side of the peripheral bezel region B2 away from the display region AA along a second direction Y. The first bezel region B1 may be in communication with the peripheral bezel region B2. For example, the first bezel region B1 may be a lower bezel of the display panel. The peripheral bezel region B2 may include a second bezel region B21 and a third bezel region B22 located at two sides of the display region AA along a first direction X. The second bezel region B21 may be in communication with the first bezel region B1, and the third bezel region B22 may be in communication with the first bezel region B1. For example, the second bezel region B21 may be a left bezel of the display panel, and the third bezel region B22 may be a right bezel of the display panel.

In some examples, as shown in FIG. 1, the display region AA may be a plat region including a plurality of sub-pixels PX forming a pixel array, the plurality of sub-pixels PX may be configured to display a dynamic picture or a static image. The display region AA may be referred to as an Active Area. In some examples, the display region AA may be in a shape of a circle or an oval. However, the present embodiment is not limited thereto. For example, the display region may be in another shape such as a shape of a rectangle. In some examples, the display panel may be a flexible panel, and accordingly the display panel may be deformable, for example, may be crimped, bent, folded, or curled.

In some examples, as shown in FIG. 1, the display region AA may include a display structure layer disposed on a base substrate, or may include a display structure layer and a touch control structure layer disposed sequentially on the base substrate. For example, in the display panel, a touch control structure may be integrated to form a structure of Touch on Thin film Encapsulation (Touch on TFE for short). The Touch on TFE structure mainly includes a Flexible Multi-Layer On Cell (FMLOC) structure and a Flexible Single-Layer On Cell (FSLOC) structure. The FMLOC structure is based on a working principle of mutual capacitance detection. Generally, a drive (Tx) electrode and a sensing (Rx) electrode are formed by using two layers of metal, and a drive chip (Integrated Circuit (IC)) achieves a touch control action by detecting mutual capacitance between the drive electrode and the sensing electrode. The FSLOC structure is based on a working principle of self-capacitance (or voltage) detection. Generally, a touch control electrode is formed by using a single layer of metal, and an integrated circuit achieves a touch control action by detecting self-capacitance (or a voltage) of the touch control electrode.

In some examples, the display structure layer may include a plurality of sub-pixels PX, a plurality of gate lines GL, and a plurality of data lines DL. The plurality of gate lines GL may extend along the first direction X, and the plurality of data lines DL may extend along the second direction Y. Orthographic projections of the plurality of gate lines GL on the base substrate may intersect with orthographic projections of the plurality of data lines DL on the base substrate, thereby forming a plurality of sub-pixel regions. One sub-pixel PX may be disposed within one sub-pixel region. The plurality of data lines DL may be electrically connected with the plurality of sub-pixels PX and the plurality of data lines DL may be configured to provide data signals to the plurality of sub-pixels PX. The plurality of gate lines GL may be electrically connected with the plurality of sub-pixels PX and the plurality of gate lines GL may be configured to provide gate drive signals to the plurality of sub-pixels PX. For example, the gate drive signals may include a scan signal, or may include a scan signal and a light emitting control signal, or may include a scan signal, a reset control signal, and a light emitting control signal.

In some examples, as shown in FIG. 1, the first direction X may be an extension direction (e.g., a row direction) of a gate line GL in the display region AA, and the second direction Y may be an extension direction (e.g., a column direction) of a data line DL in the display region AA. The first direction X and the second direction Y may intersect with each other, for example, they may be perpendicular to each other.

In some examples, one pixel unit of the display region AA may include three sub-pixels, which may be a first sub-pixel emitting light of a first color (e.g., red light), a second sub-pixel emitting light of a second color (e.g., green light), and a third sub-pixel emitting light of a third color (e.g., blue light), respectively. However, the present embodiment is not limited thereto. In some examples, one pixel unit may include four sub-pixels, which may be a sub-pixel emitting red light, a sub-pixel emitting green light, a sub-pixel emitting blue light, and a sub-pixel emitting white light, respectively. For another example, one pixel unit may include four sub-pixels, which may include one sub-pixel emitting red light, one sub-pixel emitting blue light, and two sub-pixels emitting green light.

In some examples, a shape of a sub-pixel may be a rectangle, a rhombus, a pentagon, or a hexagon. When one pixel unit includes three sub-pixels, the three sub-pixels may be arranged side by side horizontally, side by side vertically, or arranged in a manner of a Chinese character " 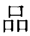 ". When one pixel unit includes four sub-pixels, the four sub-pixels may be arranged side by side horizontally, side by side vertically, or in a manner to form a square. However, the present embodiment is not limited thereto.

In some examples, one sub-pixel may include a pixel circuit and a light emitting element electrically connected with the pixel circuit. The pixel circuit may include a plurality of transistors and at least one capacitor. For example, the pixel circuit may have a 3T1C, 4T1C, 5T1C, 5T2C, 6T1C, 7T1C, or 8T1C structure. In the aforementioned circuit structures, T refers to a thin film transistor, C refers to a capacitor, a digit before T represents a quantity of thin film transistors in a circuit, and a digit before C represents a quantity of capacitors in the circuit. In some examples, the plurality of transistors in the pixel circuit may include a P-type transistor and an N-type transistor. In other examples, the plurality of transistors in the pixel circuit may be P-type transistors, or may be N-type transistors. Using a same type of transistors in the pixel circuit may simplify a process flow, reduce a process difficulty of the display panel, and improve a yield of products.

In some examples, the light emitting element may be any one of a Light Emitting Diode (LED), an Organic Light Emitting Diode (OLED), a Quantum dot Light Emitting Diode (QLED), a micro LED (including: mini-LED or micro-LED), and the like. For example, the light emitting element may be an OLED, and the light emitting element may emit red light, green light, blue light, or white light, or the like under drive of a pixel circuit corresponding to the light emitting element. A color of light emitted by the light emitting element may be determined as needed. In some examples, the light emitting element may include an anode, a cathode, and an organic emitting layer located between the anode and the cathode. The anode of the light emitting element may be electrically connected with a corresponding pixel circuit. However, the present embodiment is not limited thereto.

FIG. 2 is an equivalent circuit diagram of a pixel circuit according to at least one embodiment of the present disclosure. The pixel circuit in this example is described by taking a 8T1C structure as an example. In some examples, as shown in FIG. 2, the pixel circuit of this example may include eight transistors (i.e., a first transistor T1 to an eighth transistor T8) and one storage capacitor Cst. The first transistor T1 may also be referred to as a first reset transistor, the second transistor T2 may also be referred to as a threshold compensation transistor, the third transistor T3 may also be referred to as a drive transistor, the fourth transistor T4 may also be referred to as a data writing transistor, the fifth transistor T5 may also be referred to as a first light emitting control transistor, the sixth transistor T6 may also be referred to as a second light emitting control transistor, the seventh transistor T7 may also be referred to as a second reset transistor, and the eighth transistor T8 may also be referred to as a third reset transistor. A light emitting element EL may include an anode, a cathode, and an organic emitting layer disposed between the anode and the cathode.

In some examples, the first transistor T1, and the third transistor T3 to the eighth transistor T8 may be first-type transistors, which may be, for example, P-type transistors, and the second transistor T2 may be a second-type transistor, which may be, for example, an N-type transistor. However, the present embodiment is not limited thereto. For example, the plurality of transistors of the pixel circuit may be all P-type transistors, or all N-type transistors.

In some examples, for the first-type transistors (e.g., including the first transistor T1 and the third transistor T3 to the eighth transistor T8) of the pixel circuit, a low temperature poly silicon thin film transistor may be used, and for the second-type transistor (e.g., including the second transistor T2) of the pixel circuit, an oxide thin film transistor may be used. Low Temperature Poly Silicon (LTPS) is adopted for an active layer of a low temperature poly silicon thin film transistor and an oxide semiconductor (Oxide) is adopted for an active layer of an oxide thin film transistor. The low temperature poly silicon thin film transistor has advantages, such as a high mobility and fast charging, and the oxide thin film transistor has advantages, such as a low leakage current. The low temperature poly silicon thin film transistor and the oxide thin film transistor are integrated on one display panel to form a low temperature poly silicon oxide (LTPS + Oxide) display panel, and advantages of both the low temperature poly silicon thin film transistor and the oxide thin film transistor may be utilized, which may achieve low-frequency drive, reduce power consumption, and improve display quality.

In some examples, as shown in FIG. 2, the pixel circuit may be electrically connected with a first scan line GL1, a second scan line GL2, a data line DL, a first power supply line PL1, a second power supply line PL2, a light emitting control line EML, a first initial signal line INIT1, a second initial signal line INIT2, a third initial signal line INIT3, a first reset control line RST1, and a second reset control line RST2. The first power supply line PL1 may be configured to provide a constant first voltage signal VDD to the pixel circuit, the second power supply line PL2 may be configured to provide a constant second voltage signal VSS to the pixel circuit, and the first voltage signal VDD is greater than the second voltage signal VSS. The first scan line GL1 may be configured to provide a first scan signal SCAN1 to the pixel circuit. The second scan line GL2 may be configured to provide a second scan signal SCAN2 to the pixel circuit. The data line DL may be configured to provide a data signal to the pixel circuit. The light emitting control line EML may be configured to provide a light emitting control signal EM to the pixel circuit. The first reset control line RST1 may be configured to provide a first reset control signal RESET1 to the pixel circuit. The second reset control line may be configured to provide a second reset control signal RESET2 to the pixel circuit.

In some examples, as shown in FIG. 2, a gate of the third transistor T3 is electrically connected with a first node N1, a first electrode of the third transistor T3 is electrically connected with a second node N2, and a second electrode of the third transistor T3 is electrically connected with a third node N3. A gate of the fourth transistor T4 is electrically connected with the first scan line GL1, a first electrode of the fourth transistor T4 is electrically connected with the data line DL, and a second electrode of the fourth transistor T4 is electrically connected with the second node N2. A gate of the second transistor T2 is electrically connected with the second scan signal line GL2, a first electrode of the second transistor T2 is electrically connected with the third node N3, and a second electrode of the second transistor T2 is electrically connected with the first node N1. A gate of the fifth transistor T5 is electrically connected with the light emitting control line EML, a first electrode of the fifth transistor T5 is electrically connected with the first power supply line PL1, and a second electrode of the fifth transistor T5 is electrically connected with the second node N2. A gate of the sixth transistor T6 is electrically connected with the light emitting control line EML, a first electrode of the sixth transistor T6 is electrically connected with the third node N3, and a second electrode of the sixth transistor T6 is electrically connected with a fourth node N4. A gate of the first transistor T1 is electrically connected with the first reset control line RST1, a first electrode of the first transistor T1 is electrically connected with the first initial signal line INIT1, and a second electrode of the first transistor T1 is electrically connected with the third node N3. The first transistor T1 may be configured to reset the third node N3. A gate of the seventh transistor T7 is electrically connected with the second reset control line RST2, a first electrode of the seventh transistor T7 is electrically connected with the second initial signal line INIT2, and a second electrode of the seventh transistor T7 is electrically connected with the fourth node N4. The seventh transistor T7 may be configured to reset the fourth node N4. A gate of the eighth transistor T8 is electrically connected with the second reset control line RST2, a first electrode of the eighth transistor T8 is electrically connected with the third initial signal line INIT3, and a second electrode of the eighth transistor T8 is electrically connected with the second node N2. The eighth transistor T8 may be configured to reset the second node N2. A first electrode of the storage capacitor Cst is electrically connected with the first node N1, and a second electrode of the storage capacitor Cst is electrically connected with the first power supply line PL1.

In the example, the first node N1 is a connection point of the storage capacitor Cst, the second transistor T2, and the third transistor T3, the second node N2 is a connection point of the fifth transistor T5, the fourth transistor T4, the eighth transistor T8, and the third transistor T3, the third node N3 is a connection point of the first transistor T1, the third transistor T3, the second transistor T2, and the sixth transistor T6, and the fourth node N4 is a connection point of the sixth transistor T6, the seventh transistor T7, and the light emitting element EL.

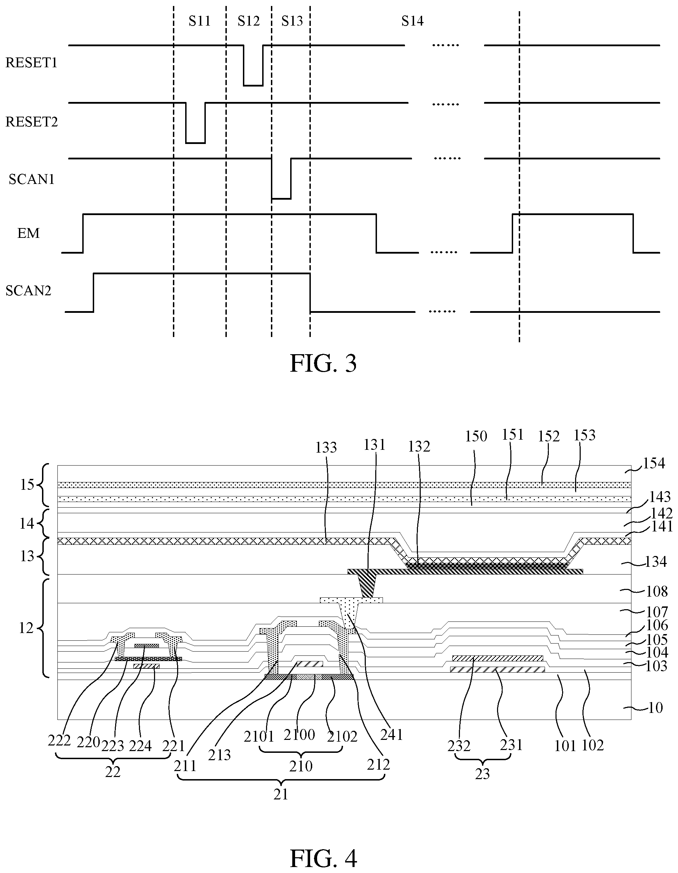

FIG. 3 is a working timing diagram of the pixel circuit provided in FIG. 2. A working process of the pixel circuit shown in FIG. 2 will be described below with reference to FIG. 3. Herein, the first transistor T1 and the third transistor T3 to the eighth transistor T8 of the pixel circuit are P-type transistors, and the second transistor T2 is an N-type transistor.

In some examples, as shown in FIGs. 2 and 3, during one frame of display period, the working process of the pixel circuit may at least include a first stage S11, a second stage S12, a third stage S13, and a fourth stage S14.

The first stage S11 is referred to as a first reset stage. The second reset control signal RESET2 provided by the second reset control line RST2 is a low-level signal, so that the seventh transistor T7 and the eighth transistor T8 are turned on, and the second scan signal SCAN2 provided by the second scan line GL2 is a high-level signal, so that the second transistor T2 is turned on. The eighth transistor T8 is turned on, so that a third initial signal provided by the third initial signal line INIT3 is provided to the second node N2. The seventh transistor T7 is turned on, so that a second initial signal provided by the second initial signal line INIT2 is provided to the fourth node N4 to initialize the fourth node N4. The first scan signal SCAN1 provided by the first scan line GL1 is a high-level signal, the first reset control signal RESET1 provided by the first reset control line RST1 is a high-level signal, and the light emitting control signal EM provided by the light emitting control line EML is a high-level signal, so that the fourth transistor T4, the first transistor T1, the fifth transistor T5, and the sixth transistor T6 are turned off. In this stage, the light emitting element EL does not emit light.

The second stage S12 is referred to as a second reset stage. The first reset control signal RESET1 provided by the first reset control line RST1 is a low-level signal, and the first transistor T1 is turned on. The second scan signal SCAN2 provided by the second scan line GL2 is a high-level signal, and the second transistor T2 is turned on. The first transistor T1 and the second transistor T2 are turned on, so that a first initial signal line provided by the first initial signal line INIT1 is provided to the first node N1 to initialize the first node N1. The second reset control signal RESET2 provided by the second reset control line RST2 is a high-level signal, the first scan signal SCAN1 provided by the first scan line GL1 is a high-level signal, and the light emitting control signal EM provided by the light emitting control line EML is a high-level signal, so that the seventh transistor T7, the eighth transistor T8, the fourth transistor T4, the fifth transistor T5, and the sixth transistor T6 are turned off. In this stage, the light emitting element EL does not emit light.

The third stage S13 is referred to as a data writing stage or a threshold compensation stage. The first scan signal SCAN1 provided by the first scan line GL1 is a low-level signal, and the fourth transistor T4 is turned on. The second scan signal SCAN2 provided by the second scan line GL2 is a high-level signal, and the second transistor T2 is turned on. In this stage, a first electrode of the storage capacitor Cst is at a low level and the third transistor T3 is turned on. The second transistor T2, the fourth transistor T4, and the third transistor T3 are turned on, so that a data voltage Vdata output by the data line DL is provided to the first node N1 through the second node N2, the turned-on third transistor T3, the third node N3, and the turned-on second transistor T2, and the storage capacitor Cst is charged with a difference between the data voltage Vdata output by the data line DL and a threshold voltage of the third transistor T3. A voltage of the first electrode (i.e., the first node N1) of the storage capacitor Cst is Vdata-|Vth|, wherein Vdata is the data voltage output by the data line DL, and Vth is the threshold voltage of the third transistor T3. The first reset control signal RESET1 provided by the first reset control line RST1 is a high-level signal, the second reset control signal RESET2 provided by the second reset control line RST2 is a high-level signal, and the light emitting control signal EM provided by the light emitting control line EML is a high-level signal, so that the first transistor T1, the seventh transistor T7, the eighth transistor T8, the fifth transistor T5, and the sixth transistor T6 are turned off.

In the fourth stage S14, the light emitting control signal EM provided by the light emitting control line EML may be switched from a high-level signal to a low-level signal, so that the fifth transistor T5 and the sixth transistor T6 are turned on. The second scan signal SCAN2 provided by the second scan line GL2 is a low-level signal, so that the second transistor T2 is turned off. The first scan signal SCAN1 provided by the first scan line GL1, the first reset control signal RESET1 provided by the first reset control line RST1, and the second reset control signal RESET2 provided by the second reset control line RST2 are high-level signals, so that the fourth transistor T4, the first transistor T1, the seventh transistor T7, and the eighth transistor T8 are turned off. The first voltage signal VDD outputted by the first power supply line PL1 may provide a drive voltage to the anode of the light emitting element EL through the turned-on fifth transistor T5, the third transistor T3, and the sixth transistor T6, driving the light emitting element EL to emit light.

In a driving process of the pixel circuit, a drive current flowing through the third transistor T3 is determined by a voltage difference between the gate and the first electrode of the third transistor T3. Since a voltage of the first node N1 is Vdata-|Vth|, the drive current of the third transistor T3 is as follows. $I = K \times {\left(Vgs-Vth\right)}^{2} = K \times {\left[\left(VDD-Vdata+\left|Vth\right|\right)-Vth\right]}^{2} = K \times {\left[VDD-Vdata\right]}^{2}$

Herein, I is the drive current flowing through the third transistor T3, that is, a drive current for driving the light emitting element, K is a constant, Vgs is the voltage difference between the gate and the first electrode of the third transistor T3, Vth is the threshold voltage of the third transistor T3, Vdata is the data voltage outputted by the data line DL, and VDD is the first voltage signal outputted by the first power supply line PL1.

It may be seen from the above formula that a current flowing through the light emitting element is independent of the threshold voltage of the third transistor T3. Therefore, the pixel circuit according to this embodiment may better compensate the threshold voltage of the third transistor T3. Moreover, the pixel circuit provided in the present embodiment may improve a display defect caused by low frequency and improve a display effect of the light emitting element.

FIG. 4 is a schematic partial sectional view of a display region according to at least one embodiment of the present disclosure. In FIG. 4, illustration is made by taking a structure of one sub-pixel of the display region as an example. In this example, illustration is made by taking a case that the pixel circuit shown in FIG. 2 includes a low temperature poly silicon thin film transistor and an oxide thin film transistor as an example.

In some examples, as shown in FIG. 4, in a direction perpendicular to the display panel, the display region of the display panel may at least include: a base substrate 10, and a circuit structure layer 12, a light emitting structure layer 13, an encapsulation structure layer 14, and a touch control structure layer 15 that are sequentially disposed on the base substrate 10. Among them, the display structure layer may include at least the circuit structure layer 12 and the light emitting structure layer 13. The circuit structure layer 12 may at least include pixel circuits of a plurality of sub-pixels, and a pixel circuit of each sub-pixel may include a plurality of transistors and at least one capacitor. The light emitting structure layer 13 may at least include light emitting elements of a plurality of sub-pixels.

In some examples, in FIG. 4, illustration is made by taking one first-type transistor 21, one second-type transistor 22, and one capacitor 23 included in each sub-pixel as an example. Herein, the first-type transistor 21 may be a low temperature poly silicon thin film transistor, and the second-type transistor 22 may be an oxide thin film transistor.

In some examples, the circuit structure layer 12 of the display region may include: a first semiconductor layer, a first gate metal layer, a second gate metal layer, a second semiconductor layer, a third gate metal layer, a first source-drain metal layer, and a second source-drain metal layer, which are disposed on the base substrate 10. A first Gate Insulation (GI) layer 101 may be disposed between the first semiconductor layer and the first gate metal layer, and a second gate insulation layer 102 may be disposed between the first gate metal layer and the second gate metal layer; a third gate insulation layer 103 may be disposed between the second gate metal layer and the second semiconductor layer; a fourth gate insulation layer 104 may be disposed between the second semiconductor layer and the third gate metal layer; an interlayer dielectric layer 105 may be disposed between the third gate metal layer and the first source-drain metal layer; a Passivation (PVX) layer 106 and a first Planarization (PLN) layer 107 may be disposed between the first source-drain metal layer and the second source-drain metal layer, and the first planarization layer 107 may be located at a side of the passivation layer 106 away from the base substrate 10; a second planarization layer 108 may be disposed at a side of the second source-drain metal layer away from the base substrate 10. Among them, the first gate insulation layer 101, the second gate insulation layer 102, the third gate insulation layer 103, the fourth gate insulation layer 104, the interlayer dielectric layer 105, and the passivation layer 106 may be inorganic insulation layers, and the first planarization layer 107 and the second planarization layer 108 may be organic insulation layers. However, the present embodiment is not limited thereto. In other examples, a buffer layer may also be disposed at a side of the first semiconductor layer close to the base substrate, and the buffer layer may prevent harmful substances in the base substrate from intruding into interior of the display panel, and may also increase adhesion of a film layer in the display panel on the base substrate. In other examples, a Bottom Shielding Metal (BSM) layer may also be provided at a side of the buffer layer close to the base substrate, and the bottom shielding metal layer may be configured to at least partially cover an active layer of a transistor of a pixel circuit to avoid an influence of external light on performance of the transistor. In some other examples, the passivation layer may be omitted between the first source-drain metal layer and the second source-drain metal layer, and only the first planarization layer may be disposed between the first source-drain metal layer and the second source-drain metal layer.

In some examples, as shown in FIG. 4, the first semiconductor layer of the display region may include at least a first active layer 210 of the first-type transistor 21. The first active layer 210 of the first-type transistor 21 may include a first region 2101, a second region 2102, and a channel region 2100 located between the first region 2101 and the second region 2102. The first gate metal layer may at least include: a first gate 213 of the first-type transistor 21, and a first electrode plate 231 of the capacitor 23. An orthographic projection of the first gate 213 of the first-type transistor 21 on the base substrate 10 may cover an orthographic projection of the channel region 2100 of the first active layer 210 on the base substrate 10. The second gate metal layer may at least include a second electrode plate 232 of the capacitor 23 and a third gate 224 of the second-type transistor 22. Orthographic projections of the second electrode plate 232 and the first electrode plate 231 of the capacitor 23 on the base substrate 10 may be at least partially overlapped, for example, the two may coincide. The second semiconductor layer may at least include a second active layer 220 of the second-type transistor 22. The third gate metal layer may at least include a second gate 223 of the second-type transistor 22. An orthographic projection of the second gate 223 of the second-type transistor 22 on the base substrate 10 and an orthographic projection of the second active layer 220 on the base substrate 10 may be partially overlapped. An orthographic projection of the third gate 224 of the second-type transistor 22 on the base substrate 10 and the orthographic projection of the second active layer 220 on the base substrate 10 may be partially overlapped. The third gate 224 may be a bottom gate of the second-type transistor 22, and the second gate 223 may be a top gate of the second-type transistor 22.

In some examples, as shown in FIG. 4, the first source-drain metal layer of the display region may at least include: a first source electrode 211 and a first drain electrode 212 of the first-type transistor 21, and a second source electrode 221 and a second drain electrode 222 of the second-type transistor 22. The interlayer dielectric layer 105 may be provided with a plurality of pixel vias (including, for example, a first pixel via, a second pixel via, a third pixel via, and a fourth pixel via) in the display region, and the interlayer dielectric layer 105, the fourth gate insulation layer 104, the third gate insulation layer 103, the second gate insulation layer 102, and the first gate insulation layer 101 in the first pixel via may be removed to expose at least part of a surface of the first region 2101 of the first active layer 210. The interlayer dielectric layer 105, the third gate insulation layer 104, the third gate insulation layer 103, the second gate insulation layer 102, and the first gate insulation layer 101 in the second pixel via may be removed to expose at least part of a surface of the second region 2102 of the first active layer 210. The interlayer dielectric layer 105, the fourth gate insulation layer 104, and the third gate insulation layer 103 in the third pixel via and the fourth pixel via may be removed to expose at least part of surfaces of two ends of the second active layer 220. The first source electrode 211 of the first-type transistor 21 may be electrically connected with the first region 2101 of the first active layer 210 through the first pixel via, and the first drain electrode 212 may be electrically connected with the second region 2102 of the first active layer 210 through the second pixel via. The second source electrode 221 of the second-type transistor 22 may be electrically connected with one end of the second active layer 220 through the third pixel via, and the second drain electrode 222 of the second-type transistor 22 may be electrically connected with the other end of the second active layer 220 through the fourth pixel via. The second source-drain metal layer may at least include a first transfer electrode 241. The first transfer electrode 241 may be electrically connected with the first drain electrode 212 of the first-type transistor 21 of the pixel circuit through a fifth pixel via disposed in the passivation layer 106 and the first planarization layer 107. In this example, an electrical connection between the pixel circuit and a light emitting element may be achieved through the first transfer electrode 241.

In some examples, a gate line of the display region may be located, for example, in the first gate metal layer and the third gate metal layer, a data line of the display region may be located, for example, in the second source-drain metal layer, and a high-potential power supply line of the display region may be located, for example, in the second source-drain metal layer. The present embodiment is not limited thereto.

In some examples, as shown in FIG. 4, the light emitting structure layer 13 may include a pixel definition layer 134 and a plurality of light emitting elements. For example, each light emitting element may include a first electrode 131, an organic emitting layer 132, and a second electrode 133 which are stacked. The first electrode 131 of the light emitting element may be an anode, and the first electrode 131 may be disposed on the second planarization layer 108 and electrically connected with the first transfer electrode 241 through a six pixel via disposed in the second planarization layer 108. The pixel definition layer 134 is disposed on the first electrode 131 and the second planarization layer 108, the pixel definition layer 134 may be provided with a plurality of pixel openings, and one pixel opening may expose at least part of a surface of a corresponding first electrode 131. At least portion of the organic emitting layer 132 may be disposed within one pixel opening and connected with a corresponding first electrode 131. The second electrode 133 may be disposed on the organic emitting layer 132 and be connected with the organic emitting layer 132. The organic emitting layer 132 may emit light of a corresponding color under drive of the first electrode 131 and the second electrode 133.

In some examples, the organic emitting layer 132 of the light emitting element may include an Emitting Layer (EML), and include at least one film layer of following: a Hole Injection Layer (HIL), a Hole Transport Layer (HTL), a Hole Block Layer (HBL), an Electron Block Layer (EBL), an Electron Injection Layer (EIL), and an Electron Transport Layer (ETL). Under drive of voltages of the first electrode 131 and the second electrode 133, light may be emitted according to a required gray scale, in virtue of light emitting characteristics of an organic material.

In some examples, emitting layers of light emitting elements of different colors may be different. For example, a red light emitting element includes a red emitting layer, a green light emitting element includes a green emitting layer, and a blue light emitting element includes a blue emitting layer. In order to reduce a process difficulty and improve a yield, a common layer may be adopted for a hole injection layer and a hole transport layer located at one side of an emitting layer, and a common layer may be adopted for an electron injection layer and an electron transport layer located at the other side of the emitting layer. In some examples, any one or more layers of the hole injection layer, the hole transport layer, the electron injection layer, and the electron transport layer may be manufactured through one-time process (one-time evaporation process or one-time inkjet printing process), and isolation may be achieved by means of a formed film layer surface segment difference or by means of a surface treatment. For example, any one or more of hole injection layers, hole transport layers, electron injection layers, and electron transport layers corresponding to adjacent sub-pixels may be isolated. In some examples, the organic emitting layer may be prepared and formed through evaporation using a Fine Metal Mask (FMM) or an open mask, or prepared and formed using an inkjet process.

In some examples, as shown in FIG. 4, the encapsulation structure layer 14 may include a first encapsulation layer 141, a second encapsulation layer 142, and a third encapsulation layer 143 which are stacked. Herein, the first encapsulation layer 141 and the third encapsulation layer 143 may be made of an inorganic material such as silicon nitride, silicon oxide, and silicon oxynitride, the inorganic material has high compactness and may prevent intrusion of water, oxygen, and the like. The second encapsulation layer 142 may be disposed between the first encapsulation layer 141 and the third encapsulation layer 143 to ensure that external moisture cannot enter the light emitting element. The second encapsulation layer 142 may be of an organic material, which may be for example, a polymer material containing a desiccant or a polymer material capable of blocking water vapor, or a polymer resin or the like to flatten a surface of the display panel and relieve a stress of the first encapsulation layer 141 and the third encapsulation layer 143. The second encapsulation layer 142 may further include a water-absorbing material such as a desiccant to absorb substances such as water and oxygen entering the interior. However, the present embodiment is not limited thereto. For example, an encapsulation structure layer may be of a five-layer stacked structure of inorganic/organic/inorganic/organic/inorganic.

In some examples, the touch control structure layer of the display region may include: a plurality of first touch control electrodes, a plurality of first connection portions, a plurality of second touch control electrodes, and a plurality of second connection portions. The plurality of first touch control electrodes may be disposed in a same layer, and adjacent first touch control electrodes may be connected through a first connection portion. The plurality of second touch control electrodes may be disposed in a same layer, and adjacent second touch control electrodes may be connected through a second connection portion.

In some examples, as shown in FIG. 4, in a direction perpendicular to the display panel, the touch control structure layer 15 of the display region may include a Touch control Buffer Layer (TBL) 150, a first touch control conductive layer 151, a Touch control interlayer Dielectric layer (TLD) 153, a second touch control conductive layer 152, and a protection layer 154 sequentially disposed. Herein, the touch control buffer layer 150 and the touch control interlayer dielectric layer 153 may be inorganic insulation layers, and the protection layer 154 may be an organic insulation layer. For example, the first touch control conductive layer 151 may include a plurality of first touch control electrodes, a plurality of second touch control electrodes, and a plurality of first connection portions. A first touch control electrode and a first connection portion may be of an interconnected integral structure. The second touch control conductive layer 152 may include a plurality of second connection portions. A second connection portion may be connected with an adjacent second touch control electrode through a via disposed in the touch control interlayer dielectric layer. However, the present embodiment is not limited thereto. In other examples, the first touch control conductive layer may include: a plurality of first touch control electrodes, a plurality of second touch control electrodes, and a plurality of second connection portions, and a second touch control electrode and a second connection portion may be of an interconnected integral structure. The second touch control conductive layer may include a plurality of first connection portions, and a first connection portion may be interconnected with an adjacent first touch control electrode through a via disposed in the touch control interlayer dielectric layer. In some examples, the first touch control electrodes may be drive (Tx) electrodes and the second touch control electrodes may be sensing (Rx) electrodes. Or, the first touch control electrodes may be sensing (Rx) electrodes and the second touch control electrodes may be drive (Tx) electrodes. The present embodiment is not limited thereto.

In some examples, the first touch control electrode and the second touch control electrode may have a rhombus shape, such as a regular rhombus, a horizontally longer rhombus, or a vertically longer rhombus. In other examples, the first touch control electrode and the second touch control electrode may have any one or more of shapes of a triangle, a square, a trapezoid, a parallelogram, a pentagon, a hexagon, and another polygon, which is not limited in the embodiments of the present disclosure.

In some examples, the first touch control electrode and the second touch control electrode may be in a form of transparent conductive electrodes. In some other examples, the first touch control electrode and the second touch control electrode may be in a form of a metal grid. The metal grid may be formed by a plurality of interweaved metal lines, and may include a plurality of grid patterns. The grid patterns may be polygons formed by a plurality of metal lines. The first touch control electrode and the second touch control electrode in the form of the metal grid have advantages of a small resistance, a small thickness, a fast reaction speed, and the like.

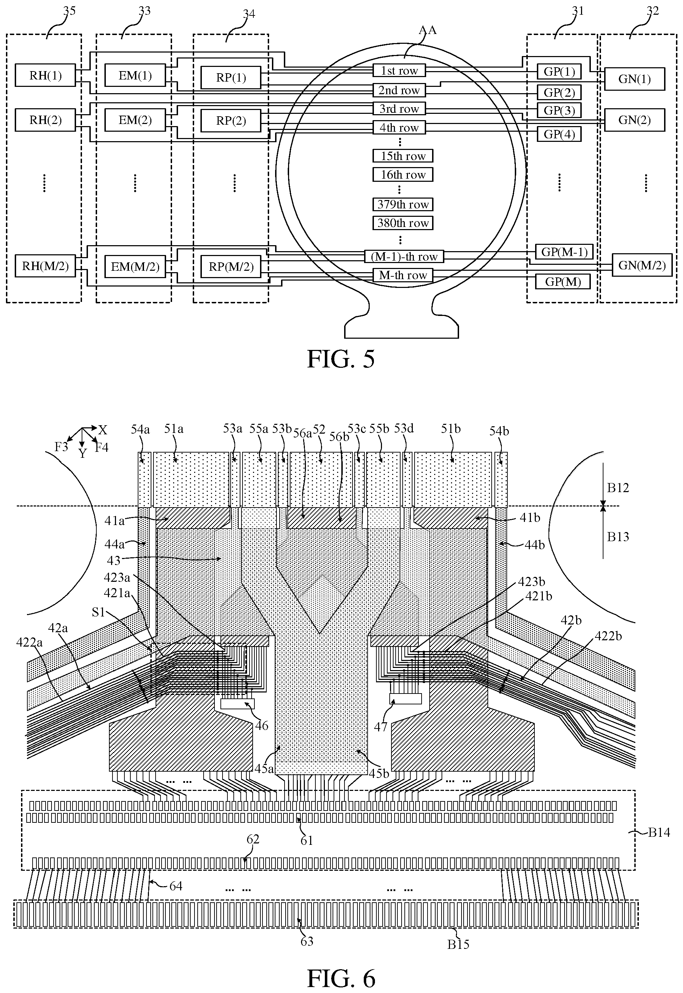

FIG. 5 is a schematic diagram of a setting of a gate drive circuit according to at least one embodiment of the present disclosure. In some examples, as shown in FIG. 5, a plurality of gate drive circuits may be disposed in the peripheral bezel region, and the plurality of gate drive circuits may include: a first scan drive circuit 31, a second scan drive circuit 32, a light emitting drive circuit 33, a first reset drive circuit 34, and a second reset drive circuit 35. The first scan drive circuit 31 may be configured to provide a first scan signal to a plurality of rows of pixel circuits in the display region AA. The second scan drive circuit 32 may be configured to provide a second scan signal to the plurality of rows of pixel circuits in the display region AA. The light emitting drive circuit 33 may be configured to provide a light emitting control signal to the plurality of rows of pixel circuits in the display region AA. The first reset drive circuit 34 may be configured to provide a first reset control signal to the plurality of rows of pixel circuits in the display region AA. The second reset drive circuit 35 may be configured to provide a second reset control signal to the plurality of rows of pixel circuits in the display region AA.

In some examples, illustration is made by taking a case in which the display region AA includes M rows of pixel circuits as an example, M being a positive integer. A plurality of rows of pixel circuits in the display region may be sequentially labeled as a 1st row to an Mth row along a direction close to the first bezel region B1. The plurality of gate drive circuits may include a first group of gate drive circuits located in the second bezel region and a second group of gate drive circuits located in the third bezel region. The first group of gate drive circuits may include following three gate drive circuits: the light emitting drive circuit 33, the first reset drive circuit 34, and the second reset drive circuit 35. For example, in the second bezel region, the second reset drive circuit 35, the light emitting drive circuit 33, and the first reset drive circuit 34 may be sequentially disposed in the first direction X along a direction close to the display region AA. The second group of gate drive circuits may include following two gate drive circuits: the first scan drive circuit 31 and the second scan drive circuit 32. For example, in the third bezel region, the first scan drive circuit 31 and the second scan drive circuit 32 may be sequentially disposed in the first direction X along a direction away from the display region AA. In some other examples, the peripheral bezel region may be provided with three gate drive circuits, the second bezel region may be provided with one gate drive circuit, and the third bezel region may be provided with two gate drive circuits. The present embodiment is not limited thereto.

In some examples, the first scan drive circuit 31 may include a plurality of cascaded first scan drive units (e.g., including GP(1) to GP(M)). Each stage first scan drive unit may be configured to provide a first scan signal to a row of pixel circuits of the display region AA. For example, a first-stage first scan drive unit GP(1) may be configured to supply a first scan signal to a first row of pixel circuits in the display region AA, and an Mth-stage first scan drive unit GP(M) may be configured to supply a first scan signal to an Mth row of pixel circuits in the display region AA.

In some examples, the second scan drive circuit 32 may include a plurality of cascaded second scan drive units (e.g., GN(1) to GN(M/2)). Each stage second scan drive unit may be configured to provide a second scan signal to two adjacent rows of pixel circuits in the display region AA. For example, a first-stage second scan drive unit GN(1) may be configured to provide a second scan signal to a first row and a second row of pixel circuits in the display region AA; an (M/2)th-stage second scan drive unit GP(M/2) may be configured to provide a second scan signal to an (M-1)th row and an Mth row of pixel circuits in the display region AA.

In some examples, the light emitting drive circuit 33 may include a plurality of cascaded light emitting drive units (e.g., EM(1) to EM(M/2)). Each stage light emitting drive unit may be configured to provide a light emitting control signal to two adjacent rows of pixel circuits in the display region AA. For example, a first-stage light emitting drive unit EM(1) may be configured to provide a light emitting control signal to the first row and the second row of pixel circuits in the display region AA; an (M/2)th-stage light emitting drive unit EM(M/2) may be configured to provide a light emitting control signal to the (M-1)th row and the Mth row of pixel circuits in the display region AA.

In some examples, the first reset drive circuit 34 may include a plurality of cascaded first reset drive units (e.g., RP(1) to RP(M/2)). Each stage first reset drive unit may be configured to provide a first reset control signal to two adjacent rows of pixel circuits in the display region AA. For example, a first-stage first reset drive unit RP(1) may be configured to provide a first reset control signal to the first row and the second row of pixel circuits in the display region AA; an (M/2)th-stage first reset drive unit RP(M/2) may be configured to provide a first reset control signal to the (M-1)th row and the Mth row of pixel circuits in the display region AA.

In some examples, the second reset drive circuit 35 may include a plurality of cascaded second reset drive units (e.g., RH(1) to RH(M/2)). Each stage second reset drive unit may be configured to provide a second reset control signal to two adjacent rows of pixel circuits in the display region AA. For example, a first-stage second reset drive unit RH(1) may be configured to provide a second reset control signal to the first row and the second row of pixel circuits in the display region AA; an (M/2)th-stage second reset drive unit RH(M/2) may be configured to provide a second reset control signal to the (M-1)th row and the Mth row of pixel circuits in the display region AA.

In some examples, as shown in FIG. 1, the first bezel region B1 may include: a bending region B12, a fan-out region B13, a first signal access region B14, and a second signal access region B15 disposed sequentially along a direction away from the display region AA. The bending region B12 may be in communication with the peripheral bezel region B2 and the fan-out region B13, and located at a side of the peripheral bezel region B2 away from the display region AA. The fan-out region B13 may be located at a side of the bending region B12 away from the display region AA. The first signal access region B14 may be located at a side of the fan-out region B13 away from the display region AA. The second signal access region B15 may be located at a side of the first signal access region B14 away from the display region AA.

In some examples, the peripheral bezel region B2 may be provided with a first peripheral power supply line, a second peripheral power supply line, and a plurality of gate drive circuits. The first peripheral power supply line may be connected with a first power supply line with which pixel circuits of a plurality of sub-pixels PX in the display region AA are electrically connected, and configured to transmit a first voltage signal. The second peripheral power supply line may extend from a left side along an edge of the display panel towards the second bezel region, and from a right side along an edge of the display panel towards the third bezel region. The second peripheral power supply line may be connected with a second power supply line, and configured to transmit a second voltage signal to a plurality of sub-pixels in the display region AA. The plurality of gate drive circuits may be arranged in the second bezel region B21 and the third bezel region B22.

In some examples, the peripheral bezel region B2 between the display region AA and the first bezel region B1 may be provided with a plurality of multiplexing circuits. For example, one multiplexing circuit may be connected with one multiplexing data line and a plurality of data lines, and configured to provide a data signal transmitted by the one multiplexing data line to the plurality of data lines.

In some examples, the peripheral bezel region B2 may also be provided with a plurality of peripheral control lines. The plurality of peripheral control lines may include a first group of peripheral control lines and a second group of peripheral control lines. For example, the first group of peripheral control lines may include a plurality of peripheral drive control lines that provide drive control signals (e.g., including a start signal, a clock signal, and a power supply signal, etc.) to the first group of gate drive circuits in the second bezel region B21; the second group of peripheral control lines may include a plurality of peripheral drive control lines that provide drive control signals to the second group of gate drive circuits in the third bezel region B22. In some other examples, each group of peripheral control lines may include a plurality of peripheral drive control lines and a plurality of peripheral multiplexing control lines, the plurality of peripheral multiplexing control lines may be connected with the plurality of multiplexing circuits and configured to provide a multiplexing control signal to a multiplexing circuit, so that the multiplexing circuit provides a data signal transmitted by the multiplexing data line to the plurality of data lines under control of the multiplexing control signal.

In some examples, the peripheral bezel region B2 may also be provided with a plurality of peripheral touch control lines. The plurality of peripheral touch control lines may be located in the touch control structure layer and connected with the first touch control electrodes or the second touch control electrodes in the display region AA.

In some examples, the bending region B12 may be configured to enable the fan-out region B13, the first signal access region B14, and the second signal access region B15 to be bent to a back surface of the display region AA. The bending region B12 may be provided with a plurality of bending connection lines to connect traces that transmit a same signal in the peripheral bezel region B2 and the fan-out region B13. The plurality of bending connection lines in the bending region B12 may be of a same layer structure, for example, may all be located in the second source-drain metal layer.

FIG. 6 is a schematic partial plan view of a first bezel region according to at least one embodiment of the present disclosure. FIG. 6 illustrates partial structures of the bending region B12, the fan-out region B13, the first signal access region B14, and the second signal access region B15. In FIG. 6, data bending connection lines, touch control bending connection lines, control bending connection lines, control connection lines, and data fan-out lines in the first bezel region are illustrated as a whole; control signal lines are only illustrated with several traces as an example. A quantity of various traces in the first bezel region is not limited in this example.

In some examples, as shown in FIG. 6, the plurality of bending connection lines in the bending region B12 may include: first power supply bending connection lines 53a, 53b, 53c, and 53d, second power supply bending connection lines 54a and 54b, a first group of data bending connection lines 51a, a second group of data bending connection lines 51b, a group of control bending connection lines 52, a first group of touch control bending connection lines 55a, and a second group of touch control bending connection lines 55b. The second power supply bending connection line 54a, the first group of data bending connection lines 51a, the first power supply bending connection line 53a, the first group of touch control bending connection lines 55a, the first power supply bending connection line 53b, the group of control bending connection lines 52, the first power supply bending connection line 53c, the second group of touch control bending connection lines 55b, the first power supply bending connection line 53d, the first group of data bending connection lines 51b, and the second power supply bending connection line 54b may be sequentially arranged along the first direction X.

In some examples, as shown in FIG. 6, the fan-out region B13 may be at least provided with a first power supply leading-out line 43, second power supply leading-out lines 44a and 44b, a plurality of data fan-out lines (for example, including a first group of data fan-out lines 41a and a second group of data fan-out lines 41b), a plurality of control connection lines (for example, including a first group of control connection lines 56a and a second group of control connection lines 56b), a plurality of control signal lines (for example, including a first group of control signal lines 42a and a second group of control signal lines 42b), and a plurality of touch control leading-out lines (for example, including a first group of touch control leading-out lines 45a and a second group of touch control leading-out lines 45b).

In some examples, as shown in FIG. 6, the first power supply leading-out line 43 may be connected with the first peripheral power supply line in the peripheral bezel region through the first power supply connection lines 53a, 53b, 53c, and 53d in the bending region B12. The first power supply leading-out line 43 may be, for example, located in the first source-drain metal layer or in the second source-drain metal layer, or may be of a double-layer trace structure disposed in the first source-drain metal layer and the second source-drain metal layer. The first power supply leading-out line 43 may at least include: a first main body portion extending along the first direction X, four connection portions extending along the second direction Y towards a side close to the bending region B12, a first power supply extension portion extending along a third direction F3, and a second power supply extension portion extending along a fourth direction F4. The third direction F3 may intersect with both the first direction X and the second direction Y, the fourth direction F4 may intersect with both the first direction X and the second direction Y, and the third direction F3 may intersect with the fourth direction F4. The four connection portions of the first power supply leading-out line 43 may be electrically connected with the four first power supply connection lines 53a, 53b, 53c, and 53d in the bending region B12 in one-to-one correspondence. The first power supply extension portion may bypass the first signal access region B14 from a left side to extend to be connected with a contact pad in the second signal access region B15, and the second power supply extension portion may bypass the first signal access region B14 from a right side to extend to be connected with a contact pad in the second signal access region B15.

In some examples, as shown in FIG. 6, the second power supply leading-out line 44a may be connected with the second peripheral power supply line in the peripheral bezel region through the second power supply connection line 54a in the bending region B12, and the second power supply leading-out line 44b may be connected with the second peripheral power supply line in the peripheral bezel region through the second power supply connection line 54b in the bending region B12. The second power supply leading-out line 44a may be located at a side of the first power supply leading-out line 43 along an opposite direction of the first direction X, and the second power supply leading-out line 44b may be located at a side of the first power supply leading-out line 43 along the first direction X. The second power supply leading-out lines 44a and 44b may both be located in the first source-drain metal layer or in the second source-drain metal layer, or may be of a double-layer trace structure disposed in the first source-drain metal layer and the second source-drain metal layer. The second power supply leading-out line 44a may bypass the first signal access region B14 from a left side to extend to be connected with a contact pad in the second signal access region B15. The second power supply leading-out line 44b may bypass the first signal access region B14 from a right side to extend to be connected with a contact pad in the second signal access region B15.

In some examples, as shown in FIG. 6, the plurality of data fan-out lines in the fan-out region B13 may extend substantially along the second direction Y towards the first signal access region B14. The plurality of data fan-out lines may include a first group of data fan-out lines 41a and a second group of data fan-out lines 41b. The first group of data fan-out lines 41a may be located between the second power supply leading-out line 44a and the first group of control connection lines 56a, and the second group of data fan-out lines 41b may be located between the second power supply leading-out line 44b and the second group of control connection lines 56b. A plurality of data fan-out lines in the first group of data fan-out lines 41a may be connected with a plurality of multiplexing data lines in the peripheral bezel region through a plurality of data bending connection lines in the first group of data bending connection lines 51a in the bending region B12, so as to achieve provision of data signals to a plurality of data lines through a plurality of multiplexing circuits; a plurality of data fan-out lines in the second group of data fan-out lines 41b may be connected with a plurality of multiplexing data lines in the peripheral bezel region through a plurality of data bending connection lines in the second group of data bending connection lines 51b in the bending region B12, so as to achieve provision of data signals to a plurality of data lines through a plurality of multiplexing circuits. For example, the first group of data fan-out lines 41a may be configured to provide data signals to sub-pixels in a left half side region of the display region, and the second group of data fan-out lines 41b may be configured to provide data signals to sub-pixels in a right half side region of the display region. A quantity of data fan-out lines in the first group of data fan-out lines 41a may be the same as a quantity of data fan-out lines in the second group of data fan-out lines 41b. For example, the plurality of data fan-out lines may be located in the first gate metal layer, or may be located in the second gate metal layer, or may be alternately disposed in the first gate metal layer and the second gate metal layer.

In some examples, as shown in FIG. 6, the plurality of control connection lines may include a first group of control connection lines 56a and a second group of control connection lines 56b. The first group of control connection lines 56a and the second group of control connection lines 56b may be located between the first group of data fan-out lines 41a and the second group of data fan-out lines 41b. The plurality of control connection lines may be connected with the plurality of peripheral control lines in the peripheral bezel region through a group of control bending connection lines 52 in the bending region B12. The first group of control connection lines 56a and the second group of control connection lines 56b may be disposed in substantially an inverted Y shape. For example, the plurality of control connection lines may be located in the first gate metal layer, or may be located in the second gate metal layer, or may be of a double-layer trace structure disposed in the first gate metal layer and the second gate metal layer.

In some examples, as shown in FIG. 6, the plurality of control signal lines in the fan-out region B13 may include a first group of control signal lines 42a and a second group of control signal lines 42b. The first group of control signal lines 42a may be connected with the first group of control connection lines 56a, and the second group of control signal lines 42b may be connected with the second group of control connection lines 56b. An orthographic projection of the first group of control signal lines 42a on the base substrate is overlapped with an orthographic projection of the first group of data fan-out lines 41a on the base substrate, and an orthographic projection of the second group of control signal lines 42b on the base substrate is overlapped with an orthographic projection of the second group of data fan-out lines 41b on the base substrate. The first group of control signal lines 42a and the second group of control signal lines 42b may be located at a side of the first main body portion of the first power supply leading-out line 43 away from the bending region B12.

In some examples, each group of control signal lines may at least include a plurality of drive control lines, and the drive control lines may be configured to provide drive controls signal to gate drive circuits. A plurality of drive control lines included in the first group of control signal lines may be configured to provide drive control signals to the first group of gate drive circuits located in the second bezel region, and a plurality of drive control lines included in the second group of control signal lines may be configured to provide drive control signals to the second group of gate drive circuits located in the third bezel region. In some other examples, each group of control signal lines may at least include a plurality of drive control lines and a plurality of multiplexing control lines, and the plurality of multiplexing control lines may be configured to provide multiplexing control signals to the plurality of multiplexing circuits in the peripheral bezel region.

In some examples, the first group of control signal lines 42a may bypass the first signal access region B14 from a left side to extend to be connected with a contact pad in the second signal access region B15; the second group of control signal lines 42b may bypass the first signal access region B14 from a right side to extend to be connected with a contact pad in the second signal access region B15.

In some examples, the fan-out region B13 may further be provided with a first electrostatic discharge circuit 46 and a second electrostatic discharge circuit 47. The first group of control signal lines 42a may be connected with the first electrostatic discharge circuit 46, and the second group of control signal lines 42b may be connected with the second electrostatic discharge circuit 47. The first electrostatic discharge circuit 46 may be configured to provide an electrostatic discharge path for the first group of control signal lines 42a, and the second electrostatic discharge circuit 47 may be configured to provide an electrostatic discharge path for the second group of control signal lines 42b. The first electrostatic discharge circuit 46 may be located between the first group of data fan-out lines 41a and the first group of touch control leading-out lines 45a, and the second electrostatic discharge circuit 47 may be located between the second group of data fan-out lines 41b and the second group of touch control leading-out lines 45b.

In some examples, as shown in FIG. 6, the plurality of touch control leading-out lines in the fan-out region B12 may extend substantially along the second direction Y towards the first signal access region B14. The plurality of touch control leading-out lines may include a first group of touch control leading-out lines 45a and a second group of touch control leading-out lines 45b. The first group of touch control leading-out lines 45a may be connected with the peripheral touch control lines in the peripheral bezel region through the first group of touch control bending connection lines 55a in the bending region B12, and the second group of touch control leading-out lines 45b may be connected with the peripheral touch control lines in the peripheral bezel region through the second group of touch control bending connection lines 55b in the bending region B12. The first group of touch control leading-out lines 45a and the second group of touch control leading-out lines 45b may be disposed in a substantially Y shape. For example, the plurality of touch control leading-out lines may be located in the first touch control conductive layer or the second touch control conductive layer of the touch control structure layer. An orthographic projection of the first group of touch control leading-out lines 45a on the base substrate may be overlapped with an orthographic projection of the first group of control connection lines 56a on the base substrate, and an orthographic projection of the second group of touch control leading-out lines 45b on the base substrate may be overlapped with an orthographic projection of the second group of control connection lines 56b on the base substrate. The first group of touch control leading-out lines 45a and the second group of touch control leading-out lines 45b may be located between the first group of control signal lines 42a and the second group of control signal lines 42b.

In some examples, as shown in FIG. 6, the first signal access region B14 may be configured to dispose a drive chip (Integrated Circuit (IC)), for example, the drive chip disposed in the first signal access region B14 may be a display drive chip or may be a Touch and Display Driver Integration (TDDI) chip. The first signal access region B14 may also be referred to as a drive chip disposing region. The drive chip may be configured to generate data signals required for driving sub-pixels and to provide the data signals to data lines of the display region.

In some examples, the first signal access region B14 may be provided with a plurality of first contact pads, and the plurality of first contact pads may include a first group of first contact pads 61 and a second group of first contact pads 62. The second group of first contact pads 62 may be located at a side of the first group of first contact pads 61 away from the bending region B12. A plurality of first contact pads in the first group of first contact pads 61 may be arranged in an array in at least one row along the first direction X. A plurality of data fan-out lines may be connected with the plurality of first contact pads in the first group of first contact pads 61 in the first signal access region B14 to be configured to receive data signals from the drive chip; a plurality of touch control leading-out lines may be connected with the plurality of first contact pads in the first group of first contact pads 61 in the first signal access region B14 to be configured to receive touch control signals from the drive chip. A plurality of first contact pads in the second group of first contact pads 62 may be arranged in one row along the first direction X.

In some examples, the second signal access region B15 may be provided with a plurality of second contact pads 63. The plurality of second contact pads 63 may be configured to bond a Flexible Printed Circuit (FPC) such that a plurality of signal lines (including, for example, a plurality of control signal lines, a first power supply leading-out line, a second power supply leading-out line, etc.) are connected with an external control apparatus through the plurality of second contact pads 63. The second signal access region B15 may also be referred to as a circuit bonding region. The second group of first contact pads 62 in the first signal access region B14 may be electrically connected with the plurality of second contact pads 63 in the second signal access region B15 through a plurality of pin connection lines 64.

In some examples, a quantity of gate drive circuits disposed in the peripheral bezel region is an odd number (for example, five), and the quantity of gate drive circuits disposed in the second bezel region and the third bezel region cannot be evenly distributed (for example, three gate drive circuits are disposed in the second bezel region and two gate drive circuits are disposed in the third bezel region), which will lead to uneven overlapping of traces of two groups of data fan-out lines and two groups of control signal lines in the first bezel region, for example, a quantity of control signal lines in the first group of control signal lines overlapped with the first group of data fan-out lines is greater than a quantity of control signal lines in the second group of control signal lines overlapped with the second group of data fan-out lines, so that parasitic capacitance generated between a plurality of data fan-out lines and overlapped traces is inconsistent, and display defects such as low gray scale dark stripes may easily occur. In this example, parasitic capacitance between a data fan-out line and a control signal line overlapped therewith is reduced by increasing a distance between the data fan-out line and the control signal line overlapped therewith, thereby improving display defects such as low gray scale dark stripes caused by uneven overlapping of the data fan-out line with the control signal line.

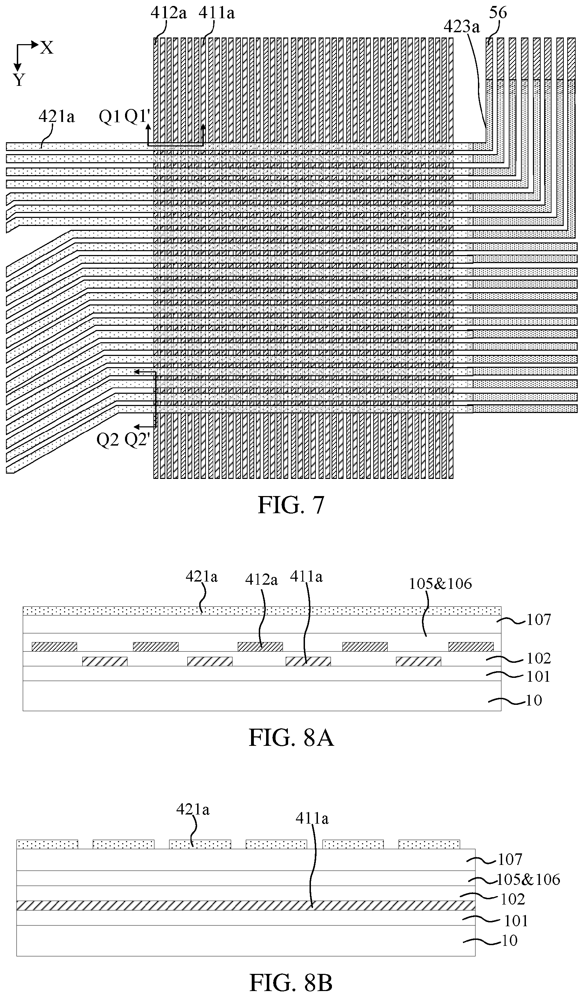

FIG. 7 is a partially enlarged schematic diagram of a region S1 in FIG. 6. FIG. 8A is a schematic partial sectional view taken along a direction Q1-Q1' in FIG. 7. FIG. 8B is a schematic partial sectional view taken along a direction Q2-Q2' in FIG. 7. Description is made below by taking a positional relationship between the first group of data fan-out lines 41a and the first group of control signal lines 42a as an example.

In some examples, as shown in FIG. 7, the first group of data fan-out lines 41a may include a plurality of first data fan-out lines 411a located in the first gate metal layer and a plurality of second data fan-out lines 412a located in the second gate metal layer. The plurality of first data fan-out lines 411a and the plurality of second data fan-out lines 412a may be disposed at intervals one by one, and orthographic projections of a first data fan-out line 411a and a second data fan-out line 412a on the base substrate are not overlapped. In other words, a distance between orthographic projections of a first data fan-out line 411a and an adjacent second data fan-out line 412a on the base substrate may be greater than 0.

In some examples, as shown in FIGs. 6 and 7, each control signal line in the first group of control signal lines 42a may include: a first control line segment 421a, a second control line segment 422a, and a third control line segment 423a. One end of the first control line segment 421a is connected with one end of the second control line segment 422a, and the other end of the first control line segment 421a is connected with one end of the third control line segment 423a. The other end of the third control line segment 423a may be connected with a control connection line 56. The other end of the second control line segment 422a may extend to be connected with a contact pad in the second signal access region. An orthographic projection of the first control line segment 421a on the base substrate is overlapped with an orthographic projection of the first group of data fan-out lines 41a on the base substrate, and orthographic projections of the second control line segment 422a and the third control line segment 423a on the base substrate are not overlapped with the orthographic projection of the first group of data fan-out lines 41a on the base substrate.

In some examples, the second control line segment 422a and the third control line segment 423a may be of a same layer structure, for example, may be located in the first source-drain metal layer. The first control line segment 421a, and the second control line segment 422a and the third control line segment 423a may be of a different layer structure. For example, the first control line segment 421a may be located at a side of the second control line segment 422a and the third control line segment 423a away from the base substrate, for example, the first control line segment 421a may be located in the second source-drain metal layer. However, the present embodiment is not limited thereto. In some other examples, a first control line segment, a second control line segment, and a third control line segment of a control signal line may be of an interconnected integral structure, for example, may be located in the second source-drain metal layer.

In some examples, as shown in FIGs. 8A and 8B, a first data fan-out line 411a is located in the first gate metal layer, a second data fan-out line 412a is located in the second gate metal layer, and a first control line segment 421a of a control signal line in the first group of control signal lines 42a is located in the second source-drain metal layer. At least one organic insulation layer (including the first planarization layer 107) and a plurality of inorganic insulation layers (for example, at least including the passivation layer 106, the interlayer dielectric layer 105, and the second gate insulation layer 102) are disposed between the first control line segment 421a of the control signal line and a first data fan-out line 411a overlapped therewith; at least one organic insulation layer (including the first planarization layer 107) and a plurality of inorganic insulation layers (for example, at least including the passivation layer 106 and the interlayer dielectric layer 105) are disposed between the first control line segment 421a of the control signal line and a second data fan-out line 412a overlapped therewith.

In some examples, as shown in FIG. 6, each control signal line in the second group of control signal lines 42b may include: a first control line segment 421b, a second control line segment 422b, and a third control line segment 423b. An orthographic projection of the first control line segment 421b on the base substrate is overlapped with an orthographic projection of the second group of data fan-out lines 41b on the base substrate, and orthographic projections of the second control line segment 422b and the third control line segment 423b on the base substrate are not overlapped with the orthographic projection of the second group of data fan-out lines 41b on the base substrate. A film layer arrangement of the second group of data fan-out lines 41b is the same as that of the first group of data fan-out lines 41a, and a film layer arrangement of the second group of control signal lines 42b is the same as that of the second group of control signal lines 42a. Therefore, no further description is made here.

In this example, by disposing one organic insulation layer between a data fan-out line and a first control line segment of a control signal line overlapped therewith, a distance between the data fan-out line and the first control line segment of the control signal line may be relatively large, so as to reduce parasitic capacitance between the data fan-out line and the control signal line, and improve display defects such as low gray scale dark stripes caused by uneven overlapping of the data fan-out line with the control signal line.

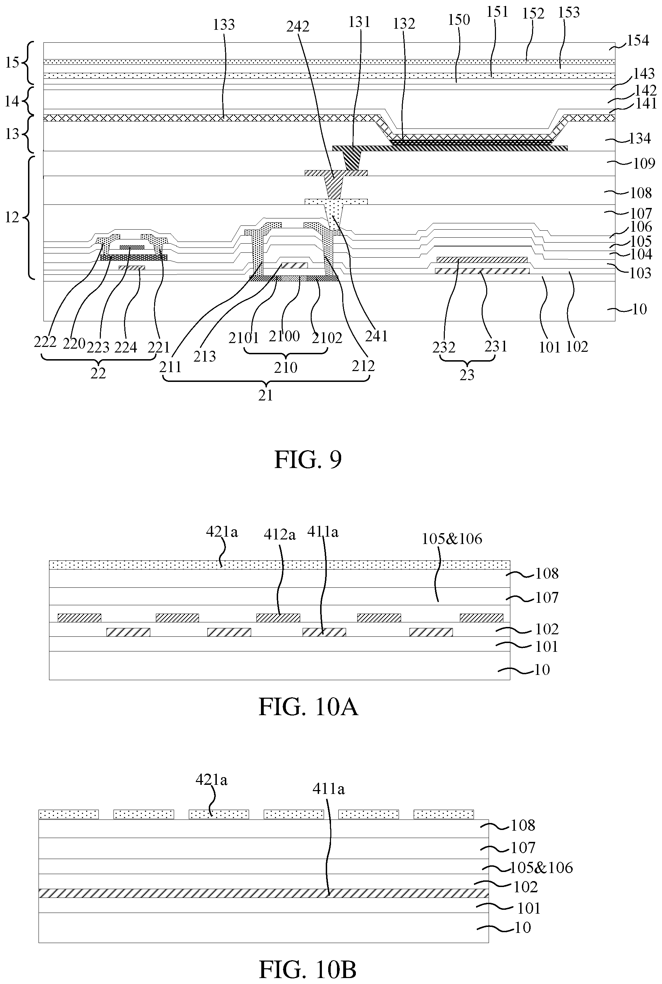

FIG. 9 is another schematic partial sectional view of a display panel according to at least one embodiment of the present disclosure. FIG. 10A is another schematic partial sectional view taken along the direction Q1-Q1' in FIG. 7. FIG. 10B is another schematic partial sectional view taken along the direction Q2-Q2' in FIG. 7.

In some examples, as shown in FIG. 9, in a direction perpendicular to the display panel, the circuit structure layer 12 in the display region may include: a first semiconductor layer, a first gate metal layer, a second gate metal layer, a second semiconductor layer, a third gate metal layer, a first source-drain metal layer, a second source-drain metal layer, and a third source-drain metal layer which are disposed on the base substrate 10. A passivation layer 106 and a first planarization layer 107 may be disposed between the first source-drain metal layer and the second source-drain metal layer, a second planarization layer 108 may be disposed between the second source-drain metal layer and the third source-drain metal layer, and a third planarization layer 109 may be disposed at a side of the third source-drain metal layer away from the base substrate 10. The first planarization layer 107, the second planarization layer 108, and the third planarization layer 109 may be organic insulation layers. The third source-drain metal layer may include at least a second transfer electrode 242. The second transfer electrode 242 may be connected with a first transfer electrode 241 located in the second source-drain metal layer through a via disposed in the second planarization layer 108. In this example, an electrical connection between a pixel circuit and a light emitting element may be achieved through the second transfer electrode 242 and the first transfer electrode 241. As to rest of a film layer structure of the display panel in this example, reference may be made to description of the embodiment shown in FIG. 4. Therefore, no further description is made here.

In some examples, as shown in FIGs. 10A and 10B, a first data fan-out line 411a is located in the first gate metal layer, a second data fan-out line 412a is located in the second gate metal layer, and a first control line segment 421a of a control signal line in the first group of control signal lines 42a may be located in the third source-drain metal layer. At least two organic insulation layers (including the first planarization layer 107 and the second planarization layer 108) and a plurality of inorganic insulation layers (for example, at least including the passivation layer 106, the interlayer dielectric layer 105, and the second gate insulation layer 102) are disposed between the first control line segment 421a of the control signal line and a first data fan-out line 411a overlapped therewith; at least two organic insulation layers (including the first planarization layer 107 and the second planarization layer 108) and a plurality of inorganic insulation layers (for example, at least including the passivation layer 106 and the interlayer dielectric layer 105) are disposed between the first control line segment 421a of the control signal line and a second data fan-out line 412a overlapped therewith. As to remaining description of the first bezel region in this example, reference may be made to description of the aforementioned embodiments. Therefore, no further description is made here.

In this example, by disposing two organic insulation layers between a data fan-out line and a first control line segment of a control signal line overlapped therewith, a distance between the data fan-out line and the first control line segment of the control signal line may be greater, which may better isolate parasitic capacitance between the data fan-out line and the control signal line, and improve display defects such as low gray scale dark stripes caused by uneven overlapping of the data fan-out line with the control signal line.

In this example, by adjusting a film layer in which the first control line segment of the control signal line is located (for example, the first control line segment is located in the second source-drain metal layer or the third source-drain metal layer), the distance between the data fan-out line and the first control line segment of the control signal line overlapped therewith may be increased, and parasitic capacitance between the data fan-out line and the control signal line overlapped therewith may be reduced, thereby effectively improving display defects such as low gray scale dark stripes caused by uneven overlapping of the data fan-out line with the control signal line.

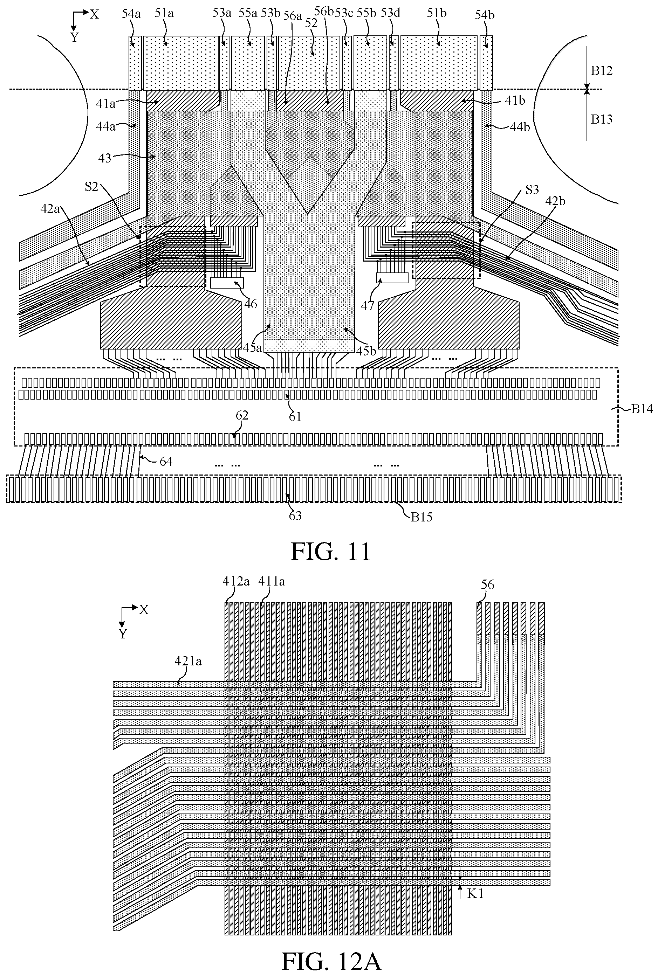

FIG. 11 is another schematic partial plan view of a first bezel region according to at least one embodiment of the present disclosure. FIG. 11 illustrates partial structures of the bending region B12, the fan-out region B13, the first signal access region B14, and the second signal access region B15. In FIG. 11, data bending connection lines, touch control bending connection lines, control bending connection lines, control connection lines, and data fan-out lines in the first bezel region are illustrated as a whole; control signal lines are only illustrated with several traces as an example. A quantity of various traces in the first bezel region is not limited in this example.

In some examples, as shown in FIG. 11, a quantity of control signal lines in the first group of control signal lines 42a is greater than a quantity of control signal lines in the second group of control signal lines 42b. Each control signal line in the first group of control signal lines 42a may be of an integral structure located in a same film layer, and each control signal line in the second group of control signal lines 42b may be of an integral structure located in a same film layer. For example, a plurality of control signal lines may be located in the first source-drain metal layer. However, the present embodiment is not limited thereto. In some other examples, a plurality of control signal lines may be located in the second source-drain metal layer or the third source-drain metal layer.

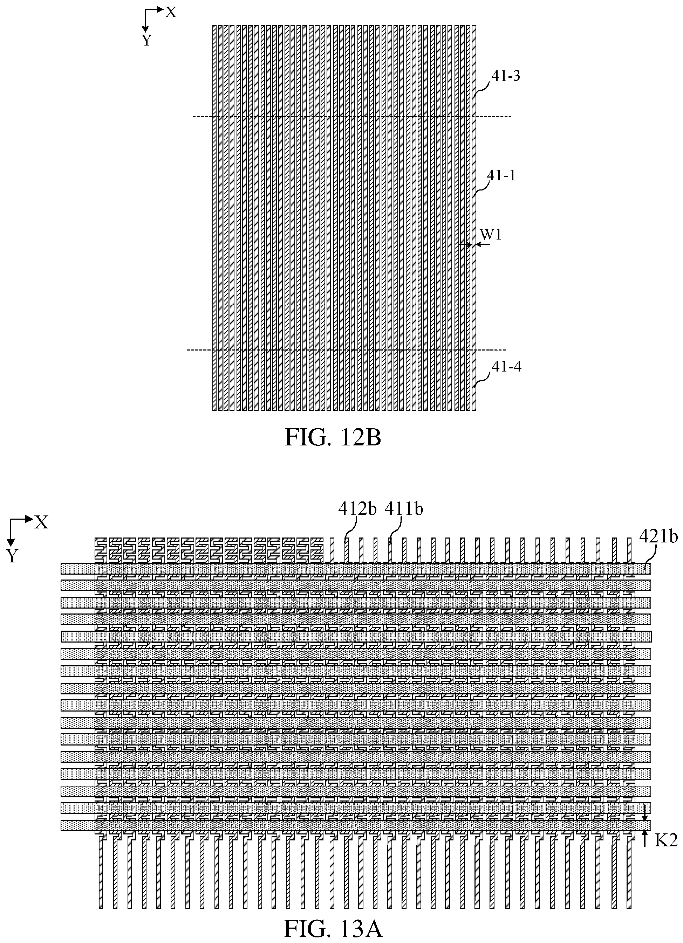

FIG. 12A is a schematic partially enlarged diagram of a region S2 in FIG. 11. FIG. 12B is a partial schematic view of a first group of data fan-out lines in FIG. 12A. In some examples, as shown in FIGs. 12A and 12B, the first group of data fan-out lines 41a may include a plurality of first data fan-out lines 411a located in the first gate metal layer and a plurality of second data fan-out lines 412a located in the second gate metal layer. The plurality of first data fan-out lines 411a and the plurality of second data fan-out lines 412a may be disposed at intervals one by one, and orthographic projections of a first data fan-out line 411a and a second data fan-out line 412a on the base substrate are not overlapped. In other words, a distance between orthographic projections of a first data fan-out line 411a and an adjacent second data fan-out line 412a on the base substrate is greater than 0.

In some examples, as shown in FIGs. 12A and 12B, each data fan-out line in the first group of data fan-out lines 41a may include: a first sub-line segment 41-1, a third sub-line segment 41-3, and a fourth sub-line segment 41-4. One end of the first sub-line segment 41-1 is connected with one end of the third sub-line segment 41-3, and the other end of the first sub-line segment 41-1 is connected with one end of the fourth sub-line segment 41-4. The other end of the third sub-line segment 41-3 may extend to one side of the bending region, and the other end of the fourth sub-line segment 41-4 may extend to one side of the first signal access region. An orthographic projection of the first sub-line segment 41-1 on the base substrate is overlapped with an orthographic projection of the first group of control signal lines 42a on the base substrate, and orthographic projections of the third sub-line segment 41-3 and the fourth sub-line segment 41-4 on the base substrate may not be overlapped with the orthographic projection of the first group of control signal lines 42a on the base substrate. The first sub-line segment 41-1, the third sub-line segment 41-3, and the fourth sub-line segment 41-4 of the data fan-out line in the first group of data fan-out lines 41a may be of an interconnected integral structure. An orthographic projection of the data fan-out line in the first group of data fan-out lines 41a on the base substrate may be a trace with a straight line shape, and the orthographic projection of the first sub-line segment 41-1 on the base substrate may be substantially in an elongated shape. A line width of the first sub-line segment 41-1 of the data fan-out line may be a first line width W1, and line widths of the third sub-line segment 41-3 and the fourth sub-line segment 41-4 may be the same as the line width of the first sub-line segment 41-1.

In some examples, as shown in FIGs. 12A and 12B, each control signal line in the first group of control signal lines 42a may include a first control line segment 421a, an orthographic projection of the first control line segment 421a on the base substrate is overlapped with an orthographic projection of a first sub-line segment 41-1 of a data fan-out line in the first group of data fan-out lines 41a on the base substrate. For example, the first control line segment 421a of each control signal line may have a third line width K1.

In some examples, an orthographic projection of each data fan-out line in the first group of data fan-out lines 41a on the base substrate and an orthographic projection of the first group of control signal lines 42a on the base substrate may have a first overlapping area. The first overlapping area may be a sum of overlapping areas of one data fan-out line in the first group of data fan-out lines 41a and all control signal lines in the first group of control signal lines 42a. First overlapping areas corresponding to a plurality of data fan-out lines in the first group of data fan-out lines 41a may be substantially the same.

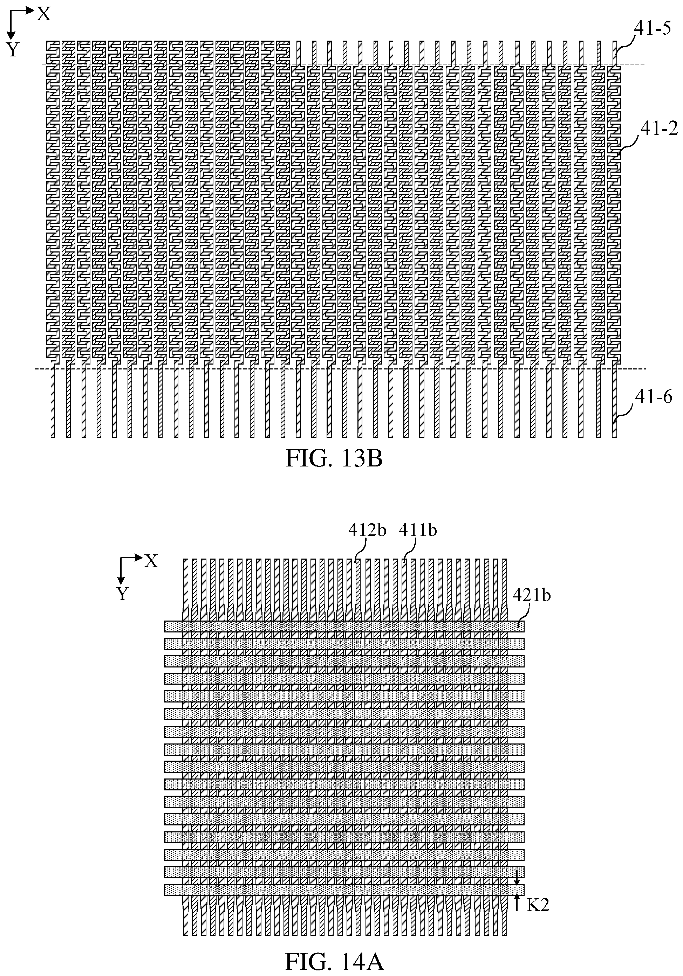

FIG. 13A is a schematic partially enlarged diagram of a region S3 in FIG. 11. FIG. 13B is a partial schematic view of the second group of data fan-out lines in FIG. 13A. In some examples, as shown in FIGs. 13A and 13B, the second group of data fan-out lines 41b may include a plurality of first data fan-out lines 411b located in the first gate metal layer and a plurality of second data fan-out lines 412b located in the second gate metal layer. The plurality of first data fan-out lines 411b and the plurality of second data fan-out lines 412b may be disposed at intervals one by one, and orthographic projections of a first data fan-out line 411b and a second data fan-out line 412b on the base substrate are not overlapped. In other words, a distance between orthographic projections of a first data fan-out line 411b and an adjacent second data fan-out line 412b on the base substrate may be greater than 0.

In some examples, as shown in FIGs. 13A and 13B, each data fan-out line in the second group of data fan-out lines 41b may include: a second sub-line segment 41-2, a fifth sub-line segment 41-5, and a sixth sub-line segment 41-6. One end of the second sub-line segment 41-2 is connected with one end of the fifth sub-line segment 41-5, and the other end of the second sub-line segment 41-2 is connected with one end of the sixth sub-line segment 41-6. The other end of the fifth sub-line segment 41-5 may extend to one side of the bending region, and the other end of the sixth sub-line segment 41-6 may extend to one side of the first signal access region. An orthographic projection of the second sub-line segment 41-2 on the base substrate is overlapped with an orthographic projection of the second group of control signal lines 42b on the base substrate, and orthographic projections of the fifth sub-line segment 41-5 and the sixth sub-line segment 41-6 on the base substrate may not be overlapped with the orthographic projection of the second group of control signal lines 42b on the base substrate. The second sub-line segment 41-2, the fifth sub-line segment 41-5, and the sixth sub-line segment 41-6 of the data fan-out line in the second group of data fan-out lines 41b may be of an interconnected integral structure.

In some examples, as shown in FIGs. 13A and 13B, each control signal line in the second group of control signal lines 42b may include a first control line segment 421b, an orthographic projection of the first control line segment 421b on the base substrate is overlapped with an orthographic projection of a second sub-line segment 41-2 of a data fan-out line in the second group of data fan-out lines 41b on the base substrate. For example, the first control line segment 421b of each control signal line may have a fourth line width K2. For example, the fourth line width K2 may be substantially the same as the third line width K1.

In some examples, an orthographic projection of each data fan-out line in the second group of data fan-out lines 41b on the base substrate may have a second overlapping area with an orthographic projection of the second group of control signal lines 42b on the base substrate. The second overlapping area may be a sum of overlapping areas of one data fan-out line in the second group of data fan-out lines 41b and all control signal lines in the second group of control signal lines 42b. Second overlapping areas corresponding to a plurality of data fan-out lines in the second group of data fan-out lines 41b may be substantially the same.

In some examples, an orthographic projection of a second sub-line segment 41-2 of a data fan-out line in the second group of data fan-out lines 41b on the base substrate may be a serpentine trace. Since a quantity of control signal lines in the second group of control signal lines is smaller than a quantity of control signal lines in the first group of control signal lines, a quantity of control signal lines with which each data fan-out line in the second group of data fan-out lines 41b is overlapped is smaller than a quantity of control signal lines with which each data fan-out line in the first group of data fan-out lines 41a is overlapped. In this example, by setting a second sub-line segment 41-2 of a data fan-out line in the second group of data fan-out lines 41b as a serpentine trace, a second overlapping area corresponding to the data fan-out line in the second group of data fan-out lines may be increased, so that the second overlapping area may be substantially the same as a first overlapping area corresponding to a data fan-out line in the first group of data fan-out lines, so as to reduce a parasitic capacitance difference between two groups of data fan-out lines and overlapped traces. In some examples, a ratio of the first overlapping area to the second overlapping area may range from 0.9 to 1.1, e.g., may be about 1.0.

In some examples, an orthographic projection of a fifth sub-line segment 41-5 or a sixth sub-line segment 41-6 of at least one data fan-out line in the second group of data fan-out lines 41b on the base substrate may be a serpentine trace. For example, orthographic projections of fifth sub-line segments 41-5 or sixth sub-line segments 41-6 of a plurality of data fan-out lines close to touch control leading-out lines in the second group of data fan-out lines 41b on the base substrate may be serpentine traces. In some examples, due to a quantity of pixel circuits with which each of a plurality of data lines in the display region is electrically connected is different, loads of the plurality of data lines are different. For example, the display region is circular or elliptical, the display region may be divided into a middle region, and left and right side regions along the first direction X, and a quantity of pixel circuits with which data lines in the middle region are connected is greater than a quantity of pixel circuits with which data lines in the left side region or the right side region are connected, so that loads of the data lines in the middle region are different from loads of data lines in the left and right side regions. In order to ensure a display effect of the display region, load compensation needs to be performed on data lines to ensure that the loads of the plurality of data lines in the display region are substantially the same. In this example, load compensation of the data lines in the display region is adjusted by setting the orthographic projection of the fifth sub-line segment 41-5 or the sixth sub-line segment 41-6 of at least one data fan-out line on the base substrate as a serpentine trace.

In some examples, line widths of the fifth sub-line segment 41-5 and the sixth sub-line segment 41-6 for which a design of a trace with a straight line shape is adopted in the second group of data fan-out lines 41b may be substantially the same as the first line width of the first sub-line segment 41-1 of the data fan-out line in the first group of data fan-out lines 41a.

In this example, a serpentine trace design is performed on some of line segments of the second group of data fan-out lines, not only an overlapping area between the second group of data fan-out lines and the second group of control signal lines may be increased, thereby reducing parasitic capacitance difference between two groups of data fan-out lines and control signal lines overlapped therewith, but also load compensation may be performed on data lines in the display region, so as to ensure that loads of a plurality of data lines in the display region are substantially the same.

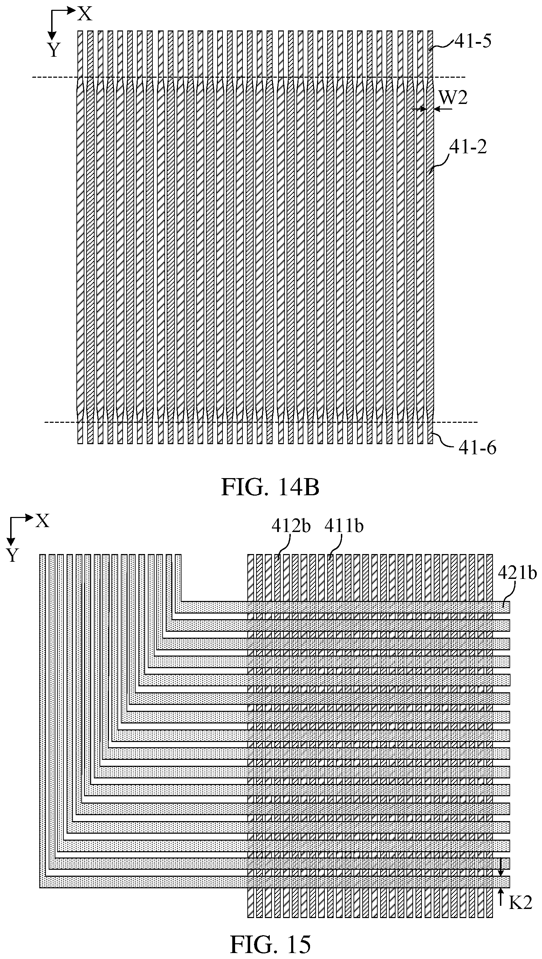

FIG. 14A is another partially enlarged schematic diagram of a region S3 in FIG. 11. FIG. 14B is a partial schematic view of the second group of data fan-out lines in FIG. 14A. In some examples, as shown in FIGs. 14A and 14B, each data fan-out line in the second group of data fan-out lines 41b may include: a second sub-line segment 41-2, a fifth sub-line segment 41-5, and a sixth sub-line segment 41-6. One end of the second sub-line segment 41-2 is connected with one end of the fifth sub-line segment 41-5, and the other end of the second sub-line segment 41-2 is connected with one end of the sixth sub-line segment 41-6. The other end of the fifth sub-line segment 41-5 may extend to one side of the bending region, and the other end of the sixth sub-line segment 41-6 may extend to one side of the first signal access region. An orthographic projection of the second sub-line segment 41-2 on the base substrate is overlapped with an orthographic projection of the second group of control signal lines 42b on the base substrate, and orthographic projections of the fifth sub-line segment 41-5 and the sixth sub-line segment 41-6 on the base substrate may not be overlapped with the orthographic projection of the second group of control signal lines 42b on the base substrate. The second sub-line segment 41-2, the fifth sub-line segment 41-5, and the sixth sub-line segment 41-6 of the data fan-out line in the second group of data fan-out lines 41b may be of an interconnected integral structure.

In some examples, as shown in FIGs. 14A and 14B, an orthographic projection of a second sub-line segment 41-2 of a data fan-out line in the second group of data fan-out lines 41b on the base substrate may be a trace with a straight line shape. The second sub-line segment 41-2 may have a second line width W2. The second line width W2 may be a maximum line width of the second sub-line segment 41-2. The second line width W2 of the second sub-line segment 41-2 may be greater than the first line width W1 of the first sub-line segment 41-1 of the data fan-out line in the first group of data fan-out lines 41a.

In some examples, orthographic projections of the fifth sub-line segment 41-5 and the sixth sub-line segment 41-6 of the data fan-out line in the second group of data fan-out lines 41b on the base substrate may both be traces with straight line shapes. Line widths of the fifth sub-line segment 41-5 and the sixth sub-line segment 41-6 may be substantially the same, for example, the same as the first line width W1. For example, a ratio of the second line width W2 to the first line width W1 may be greater than 1 and smaller than 2, e.g., may be about 1.7. In some examples, the first line width W1 may be about 5.1 microns (um) and the second line width W2 may be about 8.7 um.

In this example, by increasing the line width of the second sub-line segment of the second group of data fan-out lines, an overlapping area between the second group of data fan-out lines and the second group of control signal lines may be increased, so that a second overlapping area corresponding to a data fan-out line in the second group of data fan-out lines may be substantially the same as a first overlapping area corresponding to a data fan-out line in the first group of data fan-out lines, which increases parasitic capacitance between the second group of data fan-out lines and overlapped traces, so that parasitic capacitance between the two groups of data fan-out lines and overlapped traces is substantially the same, thereby improving display defects such as low gray scale dark stripes caused by uneven overlapping of a data fan-out line with a control signal line.

FIG. 15 is another partially enlarged schematic diagram of the region S3 in FIG. 11. In some examples, as shown in FIG. 15, a line shape and a line width of a data fan-out line in the second group of data fan-out lines 41b may be the same as a line shape and a line width of a data fan-out line in the first group of data fan-out lines 41a. A fourth line width K2 of a first control line segment 421b of at least one control signal line in the second group of control signal lines may be greater than a third line width K1 of a first control line segment 421a of a control signal line in the first group of control signal lines. For example, a fourth line width K2 of a first control line segment 421b of each control signal line in the second group of control signal lines may be the same and greater than the third line width K1.

In this example, by increasing a line width of a first control line segment of the second group of control signal lines, an overlapping area between the second group of data fan-out lines and the second group of control signal lines may be increased, so that a second overlapping area corresponding to a data fan-out line in the second group of data fan-out lines may be substantially the same as a first overlapping area corresponding to a data fan-out line in the first group of data fan-out lines, thereby increasing parasitic capacitance between the second group of data fan-out lines and control signal lines overlapped therewith, so that parasitic capacitance between the two groups of data fan-out lines and control signal lines overlapped therewith is substantially the same, thereby improving display defects such as low gray scale dark stripes caused by uneven overlapping of a data fan-out line with a control signal line.

In some examples, in the embodiments shown in FIGs. 13A to 15, in order to ensure that parasitic capacitance between a data fan-out line in the first group of data fan-out lines and the first group of control signal lines may be substantially the same as parasitic capacitance between a data fan-out line in the second group of data fan-out lines and the second group of control signal lines, the parasitic capacitance between the data fan-out line in the second group of data fan-out lines and the second group of control signal lines may be increased by increasing an overlapping area between the data fan-out line in the second group of data fan-out lines and the second group of control signal lines.

In some other examples, parasitic capacitance between a data fan-out line in the first group of data fan-out lines and the first group of control signal lines may be reduced by reducing an overlapping area between the data fan-out line in the first group of data fan-out lines and the first group of control signal lines, thereby ensuring that parasitic capacitance between the data fan-out line in the first group of data fan-out lines and the first group of control signal lines may be substantially the same as parasitic capacitance between a data fan-out line in the second group of data fan-out lines and the second group of control signal lines.

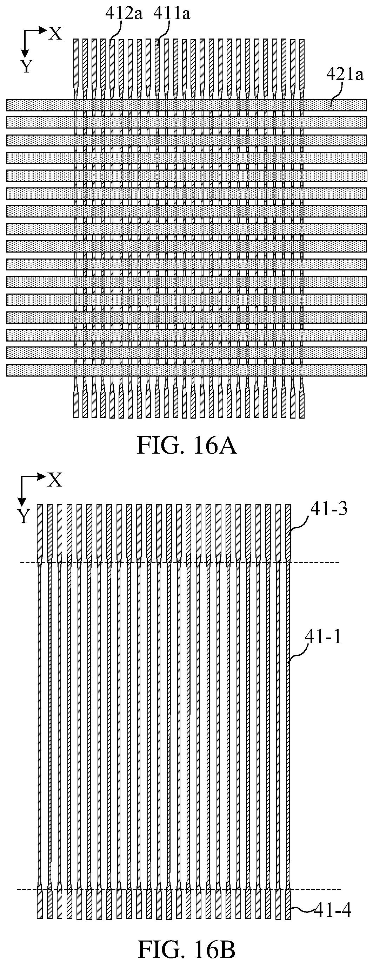

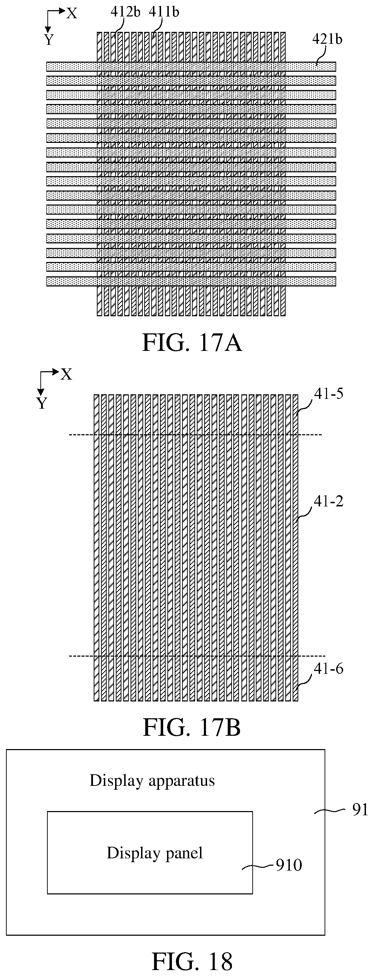

FIG. 16A is another partially enlarged schematic diagram of a region S2 in FIG. 11. FIG. 16B is a partial schematic view of a first group of data fan-out lines in FIG. 16A. FIG. 17A is another partially enlarged schematic diagram of a region S3 in FIG. 11. FIG. 17B is a partial schematic diagram of a second group of data fan-out lines in FIG. 17A.

In some examples, as shown in FIGs. 16A and 16B, each data fan-out line in the first group of data fan-out lines 41a may include: a third sub-line segment 41-3, a first sub-line segment 41-1, and a fourth sub-line segment 41-4 connected sequentially. An orthographic projection of the first sub-line segment 41-1 on the base substrate may be overlapped with an orthographic projection of the first group of control signal lines 42a on the base substrate. An orthographic projection of a data fan-out line in the first group of data fan-out lines 41a on the base substrate may be a trace with a straight line shape. A minimum line width of the first sub-line segment 41-1 may be smaller than line widths of the third sub-line segment 41-3 and the fourth sub-line segment 41-4. The line widths of the third sub-line segment 41-3 and the fourth sub-line segment 41-4 may be substantially the same.

In some examples, as shown in FIGs. 17A and 17B, each data fan-out line in the second group of data fan-out lines 41b may include a fifth sub-line segment 41-5, a second sub-line segment 41-2, and a sixth sub-line segment 41-6 that are sequentially connected. An orthographic projection of the second sub-line segment 41-2 on the base substrate may be overlapped with an orthographic projection of the second group of control signal lines 42b on the base substrate. An orthographic projection of a data fan-out line in the second group of data fan-out lines 41b on the base substrate may be a trace with a straight line shape. Line widths of the second sub-line segment 41-2, the fifth sub-line segment 41-5, and the sixth sub-line segment 41-6 may be substantially the same. A line width of the second sub-line segment 41-2 may be greater than a line width of the first sub-line segment 41-1.

In this example, by reducing a line width of a first sub-line segment of the first group of data fan-out lines, an overlapping area between the first group of data fan-out lines and the first group of control signal lines may be reduced, so that a first overlapping area corresponding to a data fan-out line in the first group of data fan-out lines may be substantially the same as a second overlapping area corresponding to a data fan-out line in the second group of data fan-out lines, which reduces parasitic capacitance between the first group of data fan-out lines and overlapped traces, so that parasitic capacitance between the two groups of data fan-out lines and overlapped traces is substantially the same, thereby improving display defects such as low gray scale dark stripes caused by uneven overlapping of a data fan-out line with a control signal line.

In some other examples, an overlapping area between the first group of data fan-out lines and the first group of control signal lines may be reduced by reducing a line width of a first control line segment of the first group of control signal lines, so that a first overlapping area corresponding to a data fan-out line in the first group of data fan-out lines may be substantially the same as a second overlapping area corresponding to a data fan-out line in the second group of data fan-out lines, thereby reducing parasitic capacitance between the first group of data fan-out lines and control signal lines overlapped therewith, so that parasitic capacitance between the two groups of data fan-out lines and control signal lines overlapped therewith is substantially the same, thereby improving display defects such as low gray scale dark stripes caused by uneven overlapping of a data fan-out line with a control signal line.

In some other examples, a first overlapping area corresponding to a data fan-out line in the first group of data fan-out lines may be made substantially the same as a second overlapping area corresponding to a data fan-out line in the second group of data fan-out lines by reducing a line width of a first sub-line segment of the first group of data fan-out lines and increasing a line width of a second sub-line segment of the second group of data fan-out lines. Or, in some other examples, a first overlapping area corresponding to a data fan-out line in the first group of data fan-out lines may be made substantially the same as a second overlapping area corresponding to a data fan-out line in the second group of data fan-out lines by reducing a line width of a first control line segment of the first group of control signal lines and increasing a line width of a first control line segment of the second group of control signal lines. Or, in some other examples, a first overlapping area corresponding to a data fan-out line in the first group of data fan-out lines may be made substantially the same as a second overlapping area corresponding to a data fan-out line in the second group of data fan-out lines by reducing a line width of a first sub-line segment of the first group of data fan-out lines and increasing a line width of a second sub-line segment of the second group of data fan-out lines, and reducing a line width of a first control line segment of the first group of control signal lines and increasing a line width of a first control line segment of the second group of control signal lines.

In the embodiments shown in FIGs. 11 to 17B, parasitic capacitance between a data fan-out line and a control signal line overlapped therewith is adjusted by adjusting an overlapping area between the data fan-out line and the control signal line overlapped therewith, so that parasitic capacitance between the first group of data fan-out lines and the second group of data fan-out lines and control signal lines overlapped therewith is substantially the same, thereby effectively improving display defects such as low gray scale dark stripes due to uneven overlapping of a data fan-out line with a control signal line.

In some other examples, parasitic capacitance between a data fan-out line and a control signal line overlapped therewith is adjusted by adjusting a film layer in which a first control line segment of the control signal line is located and adjusting an overlapping area between the data fan-out line and the control signal line overlapped therewith, so that parasitic capacitance between the first group of data fan-out lines and the second group of data fan-out lines and control signal lines overlapped therewith is substantially the same, thereby effectively improving display defects such as low gray scale dark stripes due to uneven overlapping of a data fan-out line with a control signal line. For example, first control line segments of a plurality of control signal lines may be located in the second source-drain metal layer or the third source-drain metal layer; a line width of a second sub-line segment of the second group of data fan-out lines may be greater than a line width of a first sub-line segment of the first group of data fan-out lines; or a line width of a first control line segment of the second group of control signal lines may be greater than a line width of a first control line segment of the first group of control signal lines.

An embodiment also provides a display panel, including: a base substrate, a plurality of sub-pixels, a plurality of data lines, a plurality of data fan-out lines, and a plurality of control signal lines. The base substrate includes: a display region, and a first bezel region located at a side of the display region. The plurality of sub-pixels and the plurality of data lines are located in the display region, and the plurality of data lines are connected with the plurality of sub-pixels and configured to provide data signals to the plurality of sub-pixels. The plurality of data fan-out lines and the plurality of control signal lines are located in the first bezel region, and the plurality of data fan-out lines are configured to provide data signals to the plurality of data lines. The plurality of data fan-out lines include a first group of data fan-out lines and a second group of data fan-out lines, and the plurality of control signal lines include a first group of control signal lines and a second group of control signal lines. A quantity of control signal lines in the first group of control signal lines is greater than a quantity of control signal lines in the second group of control signal lines. An orthographic projection of each data fan-out line in the first group of data fan-out lines on the base substrate is overlapped with an orthographic projection of the first group of control signal lines on the base substrate, and an orthographic projection of each data fan-out line in the second group of data fan-out lines on the base substrate is overlapped with an orthographic projection of the second group of control signal lines on the base substrate. The orthographic projection of each data fan-out line in the first group of data fan-out lines on the base substrate has a first overlapping area with the orthographic projection of the first group of control signal lines on the base substrate, and the orthographic projection of each data fan-out line in the second group of data fan-out lines on the base substrate has a second overlapping area with the orthographic projection of the second group of control signal lines on the base substrate, a ratio of the first overlapping area to the second overlapping area ranging from 0.9 to 1.1.

In this embodiment, parasitic capacitance between a data fan-out line and a control signal line that is overlapped with the data fan-out line is adjusted by adjusting an overlapping area of each data fan-out line with a plurality of control signal lines, so that parasitic capacitance between the two groups of data fan-out lines and the control signal lines is substantially the same, thereby optimizing display defects such as low gray scale dark stripes caused by uneven overlapping of a data fan-out line with a control signal line that transmits an AC signal.

In some exemplary implementation modes, each data fan-out line in the first group of data fan-out lines includes a first sub-line segment of which an orthographic projection on the base substrate is overlapped with an orthographic projection of the first group of control signal lines on the base substrate. Each data fan-out line in the second group of data fan-out lines includes a second sub-line segment of which an orthographic projection on the base substrate is overlapped with an orthographic projection of the second group of control signal lines on the base substrate. A line width of the first sub-line segment may be smaller than a line width of the second sub-line segment. In this example, by increasing the line width of the second sub-line segment of the second group of data fan-out lines, an overlapping area between the second group of data fan-out lines and the second group of control signal lines may be increased, so that a second overlapping area corresponding to a data fan-out line in the second group of data fan-out lines may be substantially the same as a first overlapping area corresponding to a data fan-out line in the first group of data fan-out lines, which increases parasitic capacitance between the second group of data fan-out lines and overlapped traces, so that parasitic capacitance between the two groups of data fan-out lines and overlapped traces is substantially the same, thereby improving display defects such as low gray scale dark stripes caused by uneven overlapping of a data fan-out line with a control signal line.

In some exemplary implementation modes, each data fan-out line in the first group of data fan-out lines includes a first sub-line segment of which an orthographic projection on the base substrate is overlapped with an orthographic projection of the first group of control signal lines on the base substrate; each data fan-out line in the second group of data fan-out lines includes a second sub-line segment of which an orthographic projection on the base substrate is overlapped with an orthographic projection of the second group of control signal lines on the base substrate; the orthographic projection of the first sub-line segment on the base substrate may be a trace with a straight line shape, and the orthographic projection of the second sub-line segment on the base substrate may be a serpentine trace. In this example, a serpentine trace design is performed on some of line segments of the second group of data fan-out lines, which may increase an overlapping area between the second group of data fan-out lines and the second group of control signal lines, thereby reducing a parasitic capacitance difference between the two groups of data fan-out lines and control signal lines overlapped therewith.

In some exemplary implementation modes, each control signal line in the first group of control signal lines includes a first control line segment of which an orthographic projection on the base substrate is overlapped with an orthographic projection of the first group of data fan-out lines on the base substrate; each control signal line in the second group of control signal lines includes a first control line segment of which an orthographic projection on the base substrate is overlapped with an orthographic projection of the second group of data fan-out lines on the base substrate. A line width of a first control line segment of at least one control signal line in the second group of control signal lines may be greater than a line width of a first control line segment of a control signal line in the first group of control signal lines. In this example, by increasing a line width of a first control line segment of the second group of control signal lines, an overlapping area between the second group of data fan-out lines and the second group of control signal lines may be increased, so that parasitic capacitance between the two groups of data fan-out lines and control signal lines overlapped therewith is substantially the same, thereby improving display defects such as low gray scale dark stripes caused by uneven overlapping of a data fan-out line with a control signal line.

Rest of description of the display panel of the example may be referred to description of the aforementioned embodiments, and thus will not be repeated here.

FIG. 18 is a schematic diagram of a display apparatus according to at least one embodiment of the present disclosure. As shown in FIG. 18, the embodiment provides a display device 91 including a display panel 910 of the aforementioned embodiments. In some examples, the display panel 910 may be an OLED display panel, such as an OLED display panel with an integrated touch control structure. The display apparatus 91 may be any product or component having a display function, such as a mobile phone, a tablet computer, a television, a display, a notebook computer, a digital photo frame, or a navigator, or may be a product or component having touch control and display functions.

In some examples, the display apparatus 91 may be a wearable display apparatus, for example, which may be worn on a human body in some manners. For example, the display apparatus 91 may be a smart watch, a smart bracelet, and the like. However, the present embodiment is not limited thereto.

The drawings of the present disclosure only involve structures involved in the present disclosure, and other structures may be referred to conventional designs. The embodiments of the present disclosure, i.e., features in the embodiments, may be combined with each other to obtain new embodiments if there is no conflict. Those of ordinary skills in the art should understand that modifications or equivalent replacements may be made to the technical solutions of the present disclosure without departing from the essence and scope of the technical solutions of the present disclosure, and shall all fall within the scope of the claims of the present disclosure.

In description of the specification, reference terms such as "an embodiment", "some embodiments", "an example" or "some examples" mean that a specific feature, structure, material, or characteristic described in connection with the embodiment or example is included in at least one embodiment or example of the present disclosure. In the specification, schematic expressions of the above terms do not necessarily refer to a same embodiment or example. Moreover, the specific feature, structure, material, or characteristic described may be combined in a proper mode in any one or more embodiments or examples. In addition, if there is no conflict, those skilled in the art may integrate and combine different embodiments or examples and features of different embodiments or examples described in the specification.

Although embodiments of the present application have been shown and described above, it may be understood that the above embodiments are exemplary, but cannot be understood as limitations on the present application. Alterations, modifications, substitutions, and variations to the above embodiments may be made by those skilled in the art within the scope of the present application.

## Claims

1. A display panel, comprising:
a base substrate, comprising: a display region, and a first bezel region located at a side of the display region;
a plurality of sub-pixels and a plurality of data lines, located in the display region, wherein the plurality of data lines are connected with the plurality of sub-pixels and configured to provide data signals to the plurality of sub-pixels;
a plurality of data fan-out lines and a plurality of control signal lines, located in the first bezel region, wherein the plurality of data fan-out lines are configured to provide data signals to the plurality of data lines; the plurality of data fan-out lines comprise a first group of data fan-out lines and a second group of data fan-out lines, and the plurality of control signal lines comprise a first group of control signal lines and a second group of control signal lines; a quantity of control signal lines in the first group of control signal lines is greater than a quantity of control signal lines in the second group of control signal lines;
an orthographic projection of each data fan-out line in the first group of data fan-out lines on the base substrate is overlapped with an orthographic projection of the first group of control signal lines on the base substrate, and an orthographic projection of each data fan-out line in the second group of data fan-out lines on the base substrate is overlapped with an orthographic projection of the second group of control signal lines on the base substrate;
at least one organic insulation layer is disposed between a data fan-out line of the plurality of data fan-out lines and a control signal line whose orthographic projection on the base substrate is overlapped with an orthographic projection of the data fan-out line on the base substrate.

2. The display panel according to claim 1, wherein a control signal line of the plurality of control signal lines comprises a first control line segment, an orthographic projection of the first control line segment on the base substrate is overlapped with an orthographic projection of the first group of data fan-out lines or the second group of data fan-out lines on the base substrate, the first control line segment is located at a side of the first group of data fan-out lines or the second group of data fan-out lines away from the base substrate, and the first control line segment intersects with an extension direction of the plurality of data fan-out lines.

3. The display panel according to claim 2, wherein in a direction perpendicular to the display panel, the display panel at least comprises: a first gate metal layer, a second gate metal layer, a first source-drain metal layer, and a second source-drain metal layer disposed along a direction away from the base substrate; at least a first planarization layer is disposed between the first source-drain metal layer and the second source-drain metal layer;
the plurality of data fan-out lines are located in at least one of the first gate metal layer and the second gate metal layer, and first control line segments of the plurality of control signal lines are located in the second source-drain metal layer.

4. The display panel according to claim 2, wherein in a direction perpendicular to the display panel, the display panel at least comprises: a first gate metal layer, a second gate metal layer, a first source-drain metal layer, a second source-drain metal layer, and a third source-drain metal layer disposed along a direction away from the base substrate; at least a first planarization layer is disposed between the first source-drain metal layer and the second source-drain metal layer, and at least a second planarization layer is disposed between the second source-drain metal layer and the third source-drain metal layer;
the plurality of data fan-out lines are located in at least one of the first gate metal layer and the second gate metal layer, and first control line segments of the plurality of control signal lines are located in the third source-drain metal layer.

5. The display panel according to claim 3 or 4, wherein the plurality of data fan-out lines comprise: a plurality of first data fan-out lines located in the first gate metal layer and a plurality of second data fan-out lines located in the second gate metal layer;
the plurality of first data fan-out lines and the plurality of second data fan-out lines are arranged at intervals one by one, and orthographic projections of the plurality of first data fan-out lines and the plurality of second data fan-out lines on the base substrate are not overlapped.

6. The display panel according to claim 2, wherein the control signal line further comprises a second control line segment and a third control line segment, the second control line segment is connected with one end of the first control line segment, the third control line segment is connected with the other end of the first control line segment, and orthographic projections of the second control line segment and the third control line segment on the base substrate are not overlapped with an orthographic projection of the plurality of data fan-out lines on the base substrate; the second control line segment and the third control line segment are of a same layer structure, and are located at a side of the first control line segment close to the base substrate.

7. The display panel according to claim 1, wherein an orthographic projection of each data fan-out line in the first group of data fan-out lines on the base substrate has a first overlapping area with the orthographic projection of the first group of control signal lines on the base substrate, and an orthographic projection of each data fan-out line in the second group of data fan-out lines on the base substrate has a second overlapping area with the orthographic projection of the second group of control signal lines on the base substrate, a ratio of the first overlapping area to the second overlapping area ranging from 0.9 to 1.1.

8. The display panel according to claim 7, wherein each data fan-out line in the first group of data fan-out lines comprises a first sub-line segment of which an orthographic projection on the base substrate is overlapped with the orthographic projection of the first group of control signal lines on the base substrate;
each data fan-out line in the second group of data fan-out lines comprises a second sub-line segment of which an orthographic projection on the base substrate is overlapped with the orthographic projection of the second group of control signal lines on the base substrate;
a line width of the first sub-line segment is smaller than a line width of the second sub-line segment.

9. The display panel according to claim 8, wherein a ratio of the line width of the second sub-line segment to the line width of the first sub-line segment is greater than 1 and smaller than 2.

10. The display panel according to claim 8, wherein each data fan-out line in the first group of data fan-out lines further comprises: a third sub-line segment connected with one end of the first sub-line segment, and a fourth sub-line segment connected with the other end of the first sub-line segment; orthographic projections of the third sub-line segment and the fourth sub-line segment on the base substrate are not overlapped with the orthographic projection of the first group of control signal lines on the base substrate; the first sub-line segment, the third sub-line segment, and the fourth sub-line segment of each data fan-out line in the first group of data fan-out lines are of an interconnected integral structure;
each data fan-out line in the second group of data fan-out lines further comprises: a fifth sub-line segment connected with one end of the second sub-line segment, and a sixth sub-line segment connected with the other end of the second sub-line segment; orthographic projections of the fifth sub-line segment and the sixth sub-line segment on the base substrate are not overlapped with the orthographic projection of the second group of control signal lines on the base substrate;
the second sub-line segment, the fifth sub-line segment, and the sixth sub-line segment of each data fan-out line in the second group of data fan-out lines are of an interconnected integral structure;
the first sub-line segment, the third sub-line segment, the fourth sub-line segment, the fifth sub-line segment, and the sixth sub-line segment have a same line width.

11. The display panel according to claim 7, wherein each data fan-out line in the first group of data fan-out lines comprises a first sub-line segment of which an orthographic projection on the base substrate is overlapped with the orthographic projection of the first group of control signal lines on the base substrate;
each data fan-out line in the second group of data fan-out lines comprises a second sub-line segment of which an orthographic projection on the base substrate is overlapped with the orthographic projection of the second group of control signal lines on the base substrate;
an orthographic projection of the first sub-line segment on the base substrate is a trace with a straight line shape, and an orthographic projection of the second sub-line segment on the base substrate is a serpentine trace.

12. The display panel according to claim 11, wherein each data fan-out line in the second group of data fan-out lines further comprises: a fifth sub-line segment connected with one end of the second sub-line segment, and a sixth sub-line segment connected with the other end of the second sub-line segment; orthographic projections of the fifth sub-line segment and the sixth sub-line segment on the base substrate are not overlapped with the orthographic projection of the second group of control signal lines on the base substrate;
the second sub-line segment, the fifth sub-line segment, and the sixth sub-line segment of each data fan-out line in the second group of data fan-out lines are of an interconnected integral structure;
an orthographic projection of a fifth sub-line segment or a sixth sub-line segment of at least one data fan-out line in the second group of data fan-out lines on the base substrate is a serpentine trace.

13. The display panel according to claim 7, wherein each control signal line in the first group of control signal lines comprises a first control line segment of which an orthographic projection on the base substrate is overlapped with an orthographic projection of the first group of data fan-out lines on the base substrate;
each control signal line in the second group of control signal lines comprises a first control line segment of which an orthographic projection on the base substrate is overlapped with an orthographic projection of the second group of data fan-out lines on the base substrate;
a line width of a first control line segment of at least one control signal line in the second group of control signal lines is greater than a line width of a first control line segment of a control signal line in the first group of control signal lines.

14. The display panel according to claim 1, wherein the base substrate further comprises a second bezel region and a third bezel region located at two sides of the display region along a first direction, and the second bezel region and the third bezel region are each in communication with the first bezel region;
the display panel further comprises a first group of gate drive circuits located in the second bezel region and a second group of gate drive circuits located in the third bezel region, wherein a quantity of gate drive circuits comprised in the first group of gate drive circuits is greater than a quantity of gate drive circuits comprised in the second group of gate drive circuits;
the first group of control signal lines comprise a plurality of first drive control lines configured to provide drive control signals to the first group of gate drive circuits;
the second group of control signal lines comprise a plurality of second drive control lines configured to provide drive control signals to the second group of gate drive circuits.

15. The display panel according to claim 14, wherein at least one sub-pixel of the plurality of sub-pixels comprises a pixel circuit;
the first group of gate drive circuits comprise a light emitting drive circuit, a first reset drive circuit, and a second reset drive circuit; the light emitting drive circuit is configured to provide a light emitting control signal to the pixel circuit, the first reset drive circuit is configured to provide a first reset control signal to the pixel circuit, and the second reset drive circuit is configured to provide a second reset control signal to the pixel circuit;
the second group of gate drive circuits comprise a first scan drive circuit and a second scan drive circuit; the first scan drive circuit is configured to provide a first scan signal to the pixel circuit, and the second scan drive circuit is configured to provide a second scan signal to the pixel circuit.

16. A display apparatus, comprising a display panel according to any one of claims 1 to 15.

17. A display panel, comprising:
a base substrate, comprising: a display region, and a first bezel region located at a side of the display region;
a plurality of sub-pixels and a plurality of data lines, located in the display region, wherein the plurality of data lines are connected with the plurality of sub-pixels and configured to provide data signals to the plurality of sub-pixels;
a plurality of data fan-out lines and a plurality of control signal lines, located in the first bezel region, wherein the plurality of data fan-out lines are configured to provide data signals to the plurality of data lines; the plurality of data fan-out lines comprise a first group of data fan-out lines and a second group of data fan-out lines, and the plurality of control signal lines comprise a first group of control signal lines and a second group of control signal lines; a quantity of control signal lines in the first group of control signal lines is greater than a quantity of control signal lines in the second group of control signal lines;
an orthographic projection of each data fan-out line in the first group of data fan-out lines on the base substrate is overlapped with an orthographic projection of the first group of control signal lines on the base substrate, and an orthographic projection of each data fan-out line in the second group of data fan-out lines on the base substrate is overlapped with an orthographic projection of the second group of control signal lines on the base substrate;
the orthographic projection of each data fan-out line in the first group of data fan-out lines on the base substrate has a first overlapping area with the orthographic projection of the first group of control signal lines on the base substrate, and the orthographic projection of each data fan-out line in the second group of data fan-out lines on the base substrate has a second overlapping area with the orthographic projection of the second group of control signal lines on the base substrate, a ratio of the first overlapping area to the second overlapping area ranging from 0.9 to 1.1.

18. The display panel according to claim 17, wherein each data fan-out line in the first group of data fan-out lines comprises a first sub-line segment of which an orthographic projection on the base substrate is overlapped with the orthographic projection of the first group of control signal lines on the base substrate;
each data fan-out line in the second group of data fan-out lines comprises a second sub-line segment of which an orthographic projection on the base substrate is overlapped with the orthographic projection of the second group of control signal lines on the base substrate;
a line width of the first sub-line segment is smaller than a line width of the second sub-line segment.

19. The display panel according to claim 17, wherein each data fan-out line in the first group of data fan-out lines comprises a first sub-line segment of which an orthographic projection on the base substrate is overlapped with the orthographic projection of the first group of control signal lines on the base substrate;
each data fan-out line in the second group of data fan-out lines comprises a second sub-line segment of which an orthographic projection on the base substrate is overlapped with the orthographic projection of the second group of control signal lines on the base substrate;
the orthographic projection of the first sub-line segment on the base substrate is a trace with a straight line shape, and the orthographic projection of the second sub-line segment on the base substrate is a serpentine trace.

20. The display panel according to claim 17, wherein each control signal line in the first group of control signal lines comprises a first control line segment of which an orthographic projection on the base substrate is overlapped with an orthographic projection of the first group of data fan-out lines on the base substrate;
each control signal line in the second group of control signal lines comprises a first control line segment of which an orthographic projection on the base substrate is overlapped with an orthographic projection of the second group of data fan-out lines on the base substrate;
a line width of a first control line segment of at least one control signal line in the second group of control signal lines is greater than a line width of a first control line segment of a control signal line in the first group of control signal lines.
